# EUROPEAN PATENT APPLICATION

(11) **EP 4 683 457 A2**
(43) Date of publication of application: **21.01.2026**
(21) Application number: 25180189.0
(22) Date of filing: 02.06.2025
(51) Int. Cl.: H10D 84/01, H10B 10/00, H10D 30/00, H10D 64/23, H10D 84/85, H10D 88/00

(54) **SEMICONDUCTOR DEVICE AND METHOD FOR FABRICATING THE SAME**

(30) Priority: 19.07.2024 KR 20240095616
(71) Applicant: Samsung Electronics Co., Ltd., Suwon-si, Gyeonggi-do 16677 (KR)
(72) Inventor: YUN, Jin Chan, 16677 Suwon-si (KR); PARK, Jae Hyun, 16677 Suwon-si (KR)
(74) Representative: Marks & Clerk LLP

(57) **Abstract**

A semiconductor device may include a substrate; a first active pattern and a second active pattern sequentially stacked on the substrate, a first gate electrode and a second gate electrode intersecting the first active pattern and the second active pattern, respectively; a first-level source/drain pattern on a sidewall of the first gate electrode and connected to the first active pattern; a second-level source/drain pattern on a sidewall of the second gate electrode and connected to the second active pattern; a first backside source/drain contact penetrating the substrate and connected to the first-level source/drain pattern; a second backside source/drain contact penetrating the substrate and connected to the second-level source/drain pattern; a connection wiring pattern connecting the first backside source/drain contact and the second backside source/drain contact; and a backside gate contact penetrating the substrate and connected to the first gate electrode and the second gate electrode.

## Description

### BACKGROUND

### 1. Field

The disclosure relates to a semiconductor device and a method for fabricating the same, and more particularly, to a semiconductor device including a stacked multi-gate transistor and a method for fabricating the same.

### 2. Description of Related Art

As one of scaling technologies to increase a density of integrated circuit (IC) devices, multi-gate transistors have been proposed in which a fin- or nanowire-shaped silicon body is formed on a substrate and then gates are formed on the surface of the silicon body.

Since these multi-gate transistors utilize three-dimensional (3D) channels, scaling is easier. Moreover, current control capabilities can be enhanced without increasing the gate length of the multi-gate transistors. Additionally, a short channel effect (SCE), where a potential of a channel region is influenced by a drain voltage, can be effectively suppressed.

To implement more devices in the same area, research is being conducted on semiconductor devices that use stacked multi-gate transistors, where multi-gate transistors in an upper region are stacked on multi-gate transistors in a lower region.

### SUMMARY

One or more embodiments of the disclosure provide a semiconductor device which may have improved integration.

According to an aspect of the disclosure, a method for fabricating a semiconductor device with improved integration is provided.

According to an aspect of the disclosure, a semiconductor device includes: a substrate including a first surface and a second surface that are opposite to each other; a first active pattern and a second active pattern sequentially stacked on the first surface, the first active pattern and the second active pattern extending in a first direction and spaced apart from each other; a first gate electrode and a second gate electrode that extend in a second direction that intersects the first direction, the first gate electrode intersecting the first active pattern, and the second gate electrode intersecting the second active pattern; a first-level source/drain pattern on a sidewall of the first gate electrode and connected to the first active pattern; a second-level source/drain pattern on a sidewall of the second gate electrode and connected to the second active pattern; a first backside source/drain contact penetrating the substrate and connected to the first-level source/drain pattern; a second backside source/drain contact penetrating the substrate and connected to the second-level source/drain pattern; a connection wiring pattern on the second surface and connecting the first backside source/drain contact and the second backside source/drain contact; and a backside gate contact penetrating the substrate and connected to the first gate electrode and the second gate electrode, wherein the second-level source/drain pattern includes: a first base portion overlapping the first-level source/drain pattern in a third direction that intersects the first direction and the second direction; and a first extension portion extending from the first base portion in the second direction and not overlapping the first-level source/drain pattern in the third direction, and wherein the second backside source/drain contact is connected to the first extension portion.

According to an aspect of the disclosure, a semiconductor device includes: a substrate; a first active pattern, a second active pattern, a third active pattern, and a fourth active pattern sequentially stacked and spaced apart from one another, on the substrate; a first gate electrode, a second gate electrode, a third gate electrode, and a fourth gate electrode sequentially stacked on the substrate and intersecting the first active pattern, the second active pattern, the third active pattern, and the fourth active pattern, respectively; a fifth gate electrode, a sixth gate electrode, a seventh gate electrode, and an eighth gate electrode sequentially stacked on the substrate and intersecting the first active pattern, the second active pattern, the third active pattern, and the fourth active pattern, respectively, wherein the fifth gate electrode, the sixth gate electrode, the seventh gate electrode, and the eighth gate electrode are spaced apart from the first gate electrode, the second gate electrode, the third gate electrode, and the fourth gate electrode; a first source/drain pattern between the first gate electrode and the fifth gate electrode and connected to the first active pattern; a second source/drain pattern connected to the first active pattern, the first gate electrode being between the first source/drain pattern and the second source/drain pattern; a third source/drain pattern connected to the first active pattern, the second gate electrode being between the first source/drain pattern and the third source/drain pattern; a fourth source/drain pattern between the second gate electrode and the sixth gate electrode and connected to the second active pattern; a fifth source/drain pattern connected to the second active pattern, the second gate electrode being between the fourth source/drain pattern and the fifth source/drain pattern; a sixth source/drain pattern connected to the second active pattern; a seventh source/drain pattern between the third gate electrode and the seventh gate electrode and connected to the third active pattern; an eighth source/drain pattern connected to the third active pattern, the seventh gate electrode being between the seventh source/drain pattern and the eighth source/drain pattern; a ninth source/drain pattern between the fourth gate electrode and the eighth gate electrode and connected to the fourth active pattern; and a tenth source/drain pattern connected to the fourth active pattern, the fourth gate electrode being between the ninth source/drain pattern and the tenth source/drain pattern, wherein the second source/drain pattern, the fifth source/drain pattern, the tenth source/drain pattern, the fifth gate electrode, and the sixth gate electrode are electrically connected to each other, and wherein the third source/drain pattern, the sixth source/drain pattern, the seventh source/drain pattern, the first gate electrode, and the second gate electrode are electrically connected to each other.

According to an aspect of the disclosure, a semiconductor device includes: a substrate including a first surface and a second surface that are opposite to each other; a first power supply line on the second surface and configured to receive a first power supply voltage; a second power supply line on the second surface and configured to receive a second power supply voltage that is different from the first power supply voltage; a latch circuit including a first inverter and a second inverter arranged in parallel on the first surface, the first inverter and the second inverter being between the first power supply line and the second power supply line; a bitline on the first surface; a complementary bitline on the first surface; a first pass transistor connecting the bitline and an output node of the first inverter; a second pass transistor connecting the complementary bitline and an output node of the second inverter; and a wordline on the first surface and connected to a gate of the first pass transistor and a gate of the second pass transistor, wherein the first inverter includes a first pull-up transistor and a first pull-down transistor connected in series between the first power supply line and the second power supply line, wherein the second inverter includes a second pull-up transistor and a second pull-down transistor connected in series between the first power supply line and the second power supply line, wherein the first pull-up transistor and the second pull-up transistor are at a first level on the first surface, wherein the first pull-down transistor and the second pull-down transistor are at a second level, that is higher than the first level, on the first surface, wherein the second pass transistor is at a third level, that is higher than the second level, on the first surface, and wherein the first pass transistor is at a fourth level, that is higher than the third level, on the first surface.

At least some of the above and other features of the invention are set out in the claims.

The above and other aspects and effects of embodiments of the disclosure will become more apparent to one of ordinary skill in the art to which the disclosure pertains by referencing the detailed description of the disclosure given below.

### BRIEF DESCRIPTION OF DRAWINGS

The above and other aspects and features of the disclosure will become more apparent by describing in detail example embodiments thereof with reference to the attached drawings, in which:
FIG. 1 is an example circuit diagram for explaining a semiconductor device according to one or more embodiments.
FIG. 2 is an example layout view for explaining the semiconductor device according to one or more embodiments.
FIG. 3 is a schematic cross-sectional view taken along a line A-A of FIG. 2.
FIG. 4 is a schematic cross-sectional view taken along a line B-B of FIG. 2.
FIG. 5 is a schematic cross-sectional view taken along a line C-C of FIG. 2.
FIG. 6 is a schematic cross-sectional view taken along a line D-D of FIG. 2.
FIG. 7 is a schematic cross-sectional view taken along a line E-E of FIG. 2.
FIG. 8 is a schematic cross-sectional view taken along a line F-F of FIG. 2.
FIG. 9 is a schematic cross-sectional view taken along a line G-G of FIG. 2.
FIGS. 10 through 39 are cross-sectional views for explaining a method for manufacturing a semiconductor device according to one or more embodiments.

### DETAILED DESCRIPTION

It will be understood that, although the terms "first," "second," etc., may be used herein to describe various elements, these elements should not be limited by these terms. These terms are only used to distinguish one element from another element. Thus, for example, a first element, a first component, or a first section discussed below could be termed a second element, a second component, or a second section without departing from the scope of the disclosure.

It will be understood that when an element or layer is referred to as being "on," "connected to," or "coupled to" another element or layer, it can be directly on, connected to, or coupled to the other element or layer or intervening elements or layers may be present. In contrast, when an element or layer is referred to as being "directly on," "directly connected to," or "directly coupled to" another element or layer, there are no intervening elements or layers present.

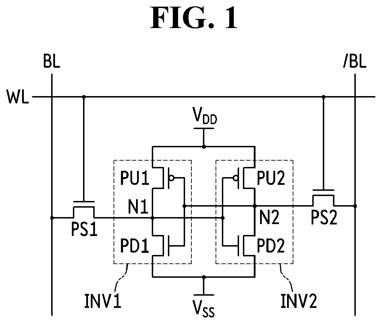

A semiconductor device according to example embodiments will hereinafter be described with reference to FIGS. 1 through 9. The embodiments described below describe a static random-access memory (SRAM) device as an example semiconductor device, but embodiments of the disclosure are not limited thereto. Those skilled in the art to which the disclosure pertains will understand that embodiments of the disclosure are applicable not only to an SRAM device but also to other various semiconductor devices, such as a logic device, a complementary metal-oxide semiconductor (CMOS) inverter, etc.

FIG. 1 is an example circuit diagram for explaining a semiconductor device according to one or more embodiments.

Referring to FIG. 1, the semiconductor device according to one or more embodiments may include a pair of a first inverter INV1 and a second inverter INV2 that are connected in parallel between a power supply node V_{DD} and a ground node V_{SS}, and a first pass transistor PS1 and a second pass transistor PS2 that are respectively connected to output nodes N1 and N2 of the first inverter INV1 and the second inverter INV2.

To form a latch circuit, the output node N1 of the first inverter INV1 may be connected to the input node of the second inverter INV2, and the output node N2 of the second inverter INV2 may be connected to the input node of the first inverter INV1.

The first inverter INV1 may include a first pull-up transistor PU1 and a first pull-down transistor PD1 that are connected in series between the power supply node V_{DD} and the ground node V_{SS}, and the second inverter INV2 may include a second pull-up transistor PU2 and a second pull-down transistor PD2 that are connected in series between the power supply node V_{DD} and the ground node V_{SS}. The first pull-up transistor PU1 and the second pull-up transistor PU2 may be P-type field-effect transistors (PFETs), and the first pull-down transistor PD1 and the second pull-down transistor PD2 may be N-type field-effect transistors (NFETs).

The first pass transistor PS1 may connect a bitline BL to the output node N1 of the first inverter INV1. The second pass transistor PS2 may connect a complementary bitline /BL to the output node N2 of the second inverter INV2. The gate of the first pass transistor PS1 and the gate of the second pass transistor PS2 may be commonly connected to a wordline WL.

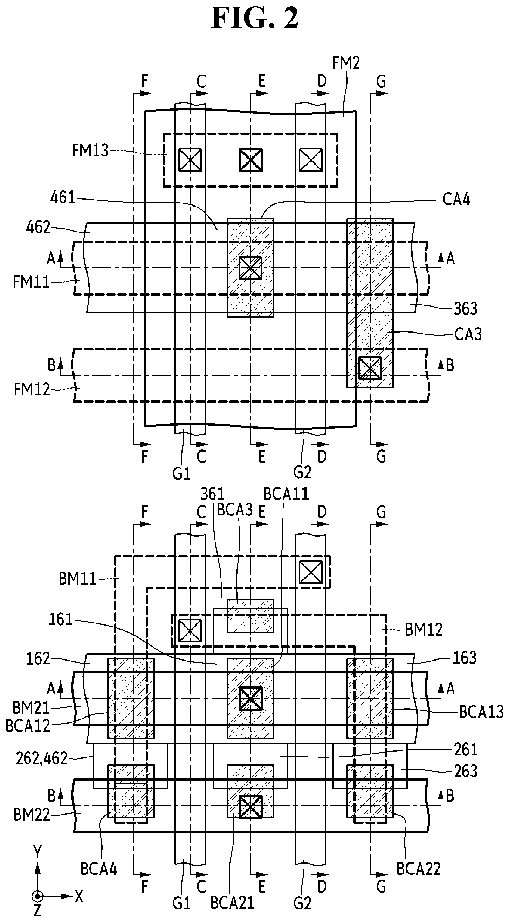

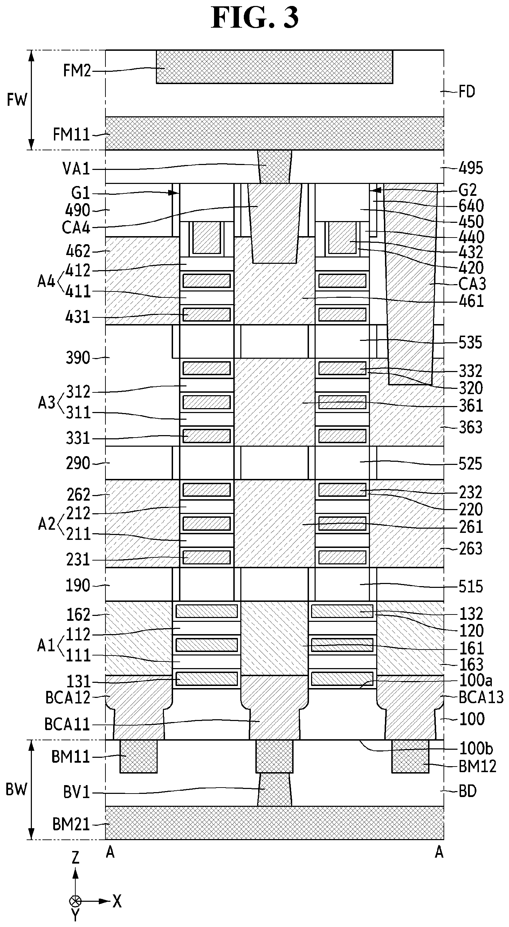

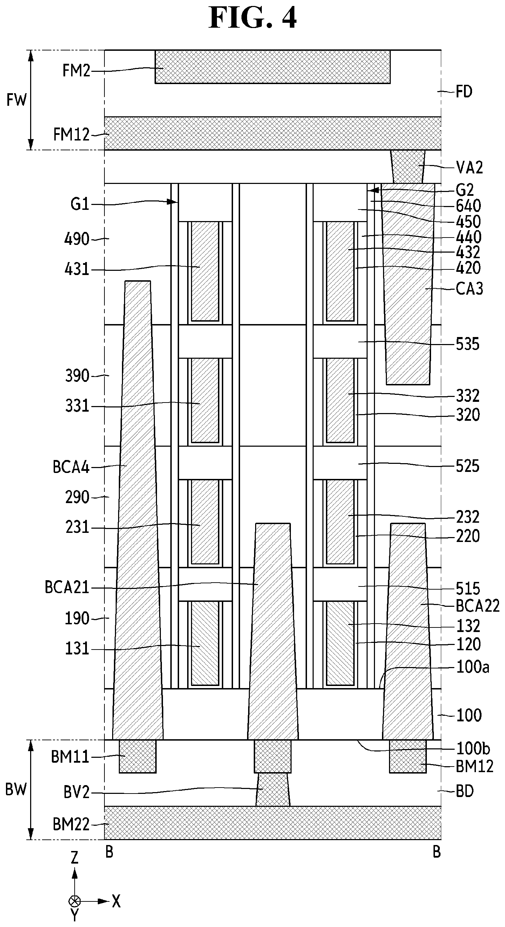

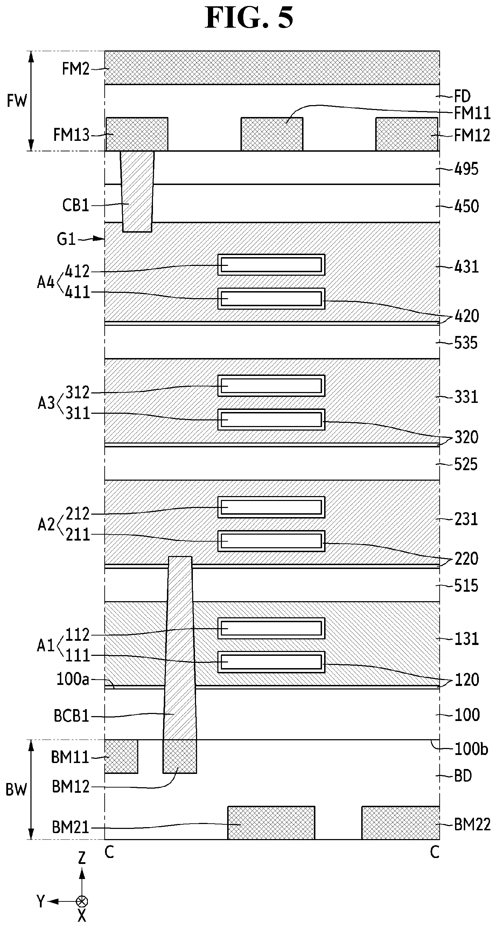

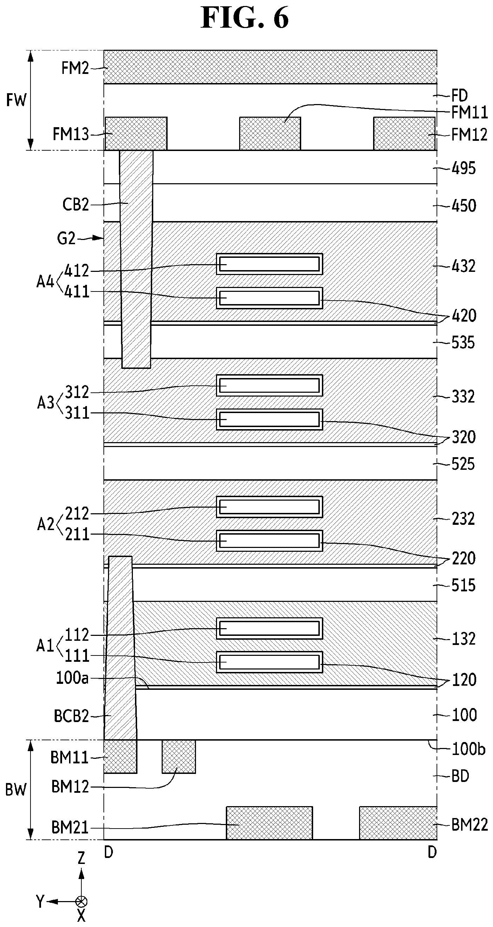

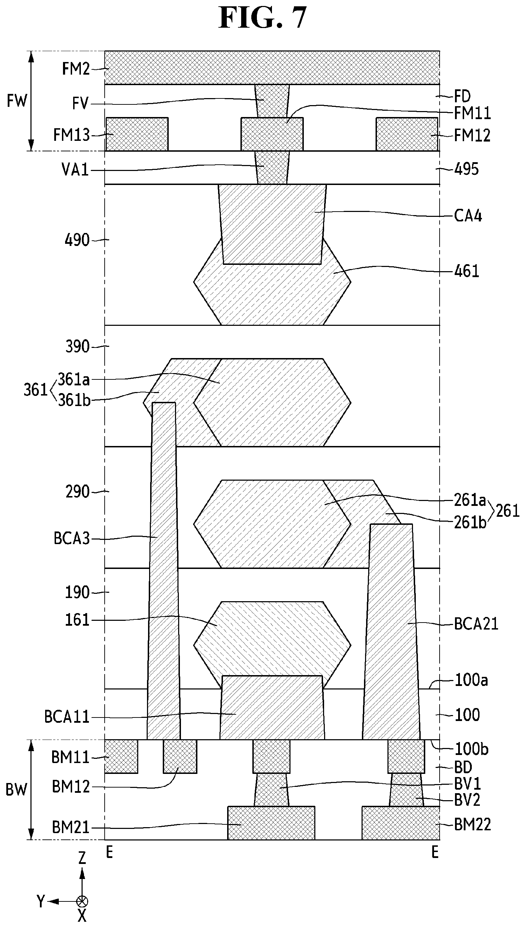

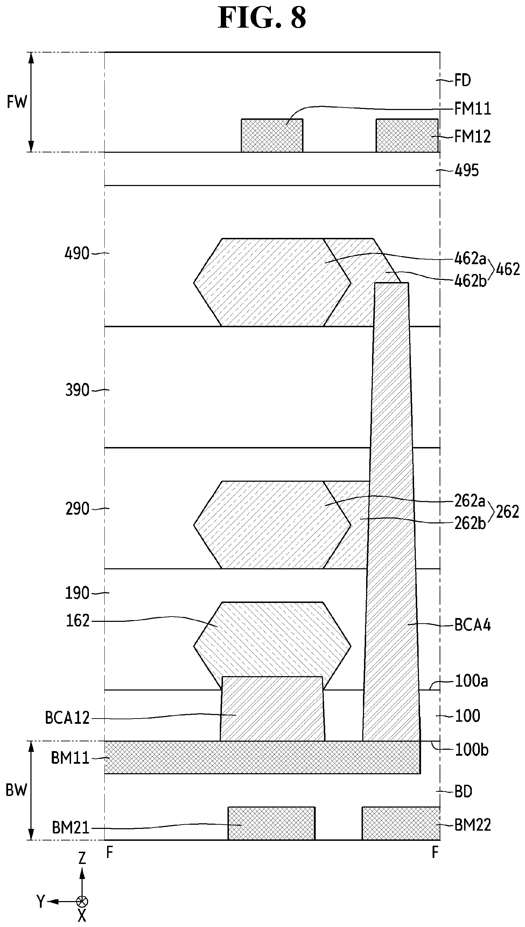

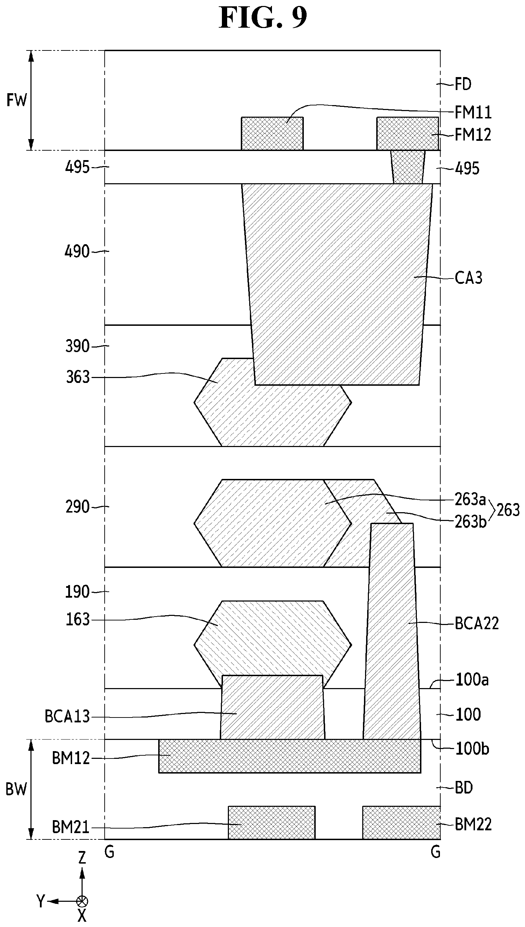

FIG. 2 is an example layout view for explaining the semiconductor device according to one or more embodiments. FIG. 3 is a schematic cross-sectional view taken along a line A-A of FIG. 2. FIG. 4 is a schematic cross-sectional view taken along a line B-B of FIG. 2. FIG. 5 is a schematic cross-sectional view taken along a line C-C of FIG. 2. FIG. 6 is a schematic cross-sectional view taken along a line D-D of FIG. 2. FIG. 7 is a schematic cross-sectional view taken along a line E-E of FIG. 2. FIG. 8 is a schematic cross-sectional view taken along a line F-F of FIG. 2. FIG. 9 is a schematic cross-sectional view taken along a line G-G of FIG. 2.

Referring to FIGS. 1 through 9, the semiconductor device according to one or more embodiments may include a substrate 100, first through fourth active patterns A1 through A4, a first gate structure G1, a second gate structure G2, first-level source/drain patterns (e.g., first through third source/drain patterns 161 through 163), second-level source/drain patterns (e.g., the fourth through sixth source/drain patterns 261 through 263), third-level source/drain patterns (e.g., a seventh source/drain pattern 361 and an eighth source/drain pattern 363), fourth-level source/drain patterns (e.g., a ninth source/drain pattern 461 and a tenth source/drain pattern 462), first, second, third, and fourth interlayer insulating films 190, 290, 390, and 490, frontside source/drain contacts (e.g., a first frontside source/drain contact CA4 and a second frontside source/drain contact CA3), a frontside wiring structure FW, backside source/drain contacts (e.g., the first through seventh backside source/drain contacts BCA11, BCA12, BCA13, BCA21, BCA22, BCA3, and BCA4), and a backside wiring structure BW.

The substrate 100 may be a bulk silicon (Si) substrate or an Si-on-insulator (SOI) substrate. Alternatively, the substrate 100 may be an Si substrate, or may include other materials such as, for example, silicon-germanium (SiGe), SiGe-on-insulator (SGOI), indium antimonide, a lead telluride compound, indium arsenide, indium phosphide, gallium arsenide, or gallium antimonide. Alternatively, the substrate 100 may be a substrate where an epitaxial layer is formed on a base substrate.

In one or more embodiments, the substrate 100 may be an insulating substrate that includes an insulating material. For example, the substrate 100 may include at least one from among silicon oxide, silicon oxynitride, silicon oxycarbonitride, and a combination thereof, but embodiments of the disclosure are not limited thereto. For example, the substrate 100 may include a silicon oxide film.

The substrate 100 may include a first surface 100a and a second surface 100b that are opposite to each other. Here, the first surface 100a may also be referred to as the front side of the substrate 100, and the second surface 100b may also be referred to as the back side of the substrate 100.

The first through fourth active patterns A1 through A4 may be formed on the substrate 100. The first through fourth active patterns A1 through A4 may be sequentially stacked on the first surface 100a to be spaced apart from one another. For example, the first through fourth active patterns A1 through A4 may be spaced apart from one another in a third direction Z that intersects the first surface 100a, and may extend in a first direction X that is parallel to the first surface 100a.

The first through fourth active patterns A1 through A4 may each include an elemental semiconductor material such as Si or germanium (Ge). Alternatively, the first through fourth active patterns A1 through A4 may each include a compound semiconductor such as, for example, a Group IV-IV compound semiconductor or a Group III-V compound semiconductor. The Group IV-IV compound semiconductor may include, for example, a binary or ternary compound containing at least two from among carbon (C), Si, Ge, and tin (Sn), or a compound obtained by doping the binary or ternary compound with a Group IV element. The Group III-V compound semiconductor may include, for example, a binary, ternary, or quaternary compound obtained by combining at least one Group III element such as aluminum (Al), gallium (Ga), or indium (In) with at least one Group V element such as phosphorus (P), arsenic (As), or antimony (Sb).

In one or more embodiments, the first active pattern A1 may be provided as the channel region of a PFET, and the second through fourth active patterns A2 through A4 may be provided as the channel region of an NFET.

In one or more embodiments, each of the first through fourth active patterns A1 through A4 may include a plurality of bridge patterns that are sequentially stacked on the first surface 100a and are spaced apart from one another. For example, the first active pattern A1 may include first bridge patterns 111 and second bridge patterns 112. For example, the second active pattern A2 may include third bridge patterns 211 and fourth bridge patterns 212. For example, the third active pattern A3 may include fifth bridge patterns 311 and sixth bridge patterns 312. For example, the fourth active pattern A4 may include seventh bridge patterns 411 and eighth bridge patterns 412. The first through fourth active patterns A1 through A4 may be used as the channel regions of MBCFETs^{®}, which include multi-bridge channels. The number of bridge patterns included in each of the first through fourth active patterns A1 through A4 is merely an example and is not particularly limited.

The first gate structure G1 and the second gate structure G2 may be formed on the substrate 100 and the first through fourth active patterns A1 through A4. The first gate structure G1 and the second gate structure G2 may be spaced apart from each other and intersect the first through fourth active patterns A1 through A4. For example, the first gate structure G1 and the second gate structure G2 may be spaced apart from each other in the first direction X, and each may extend in a second direction Y, which is parallel to the first surface 100a and intersects the first direction X. The first through fourth active patterns A1 through A4 may extend in the first direction X and penetrate the first gate structure G1 and the second gate structure G2.

The first gate structure G1 may include first, second, third, and fourth gate electrodes 131, 231, 331, and 431. The first, second, third, and fourth gate electrodes 131, 231, 331, and 431 may be sequentially stacked on the first surface 100a. The first, second, third, and fourth gate electrodes 131, 231, 331, and 431 may intersect the first, second, third, and fourth active patterns A1, A2, A3, and A4, respectively. For example, the first active pattern A1 may extend in the first direction X and penetrate the first gate electrode 131. For example, the second active pattern A2 may extend in the first direction X and penetrate the second gate electrode 231. For example, the third active pattern A3 may extend in the first direction X and penetrate the third gate electrode 331. For example, the fourth active pattern A4 may extend in the first direction X and penetrate the fourth gate electrode 431.

The second gate structure G2 may include fifth, sixth, seventh, and eighth gate electrodes 132, 232, 332, and 432. The fifth, sixth, seventh, and eighth gate electrodes 132, 232, 332, and 432 may be sequentially stacked on the first surface 100a. The fifth, sixth, seventh, and eighth gate electrodes 132, 232, 332, and 432 may intersect the first through fourth active patterns A1 through A4, respectively. For example, the first active pattern A1 may extend in the first direction X and penetrate the fifth gate electrode 132. For example, the second active pattern A2 may extend in the first direction X and penetrate the sixth gate electrode 232. For example, the third active pattern A3 may extend in the first direction X and penetrate the seventh gate electrode 332. For example, the fourth active pattern A4 may extend in the first direction X and penetrate the eighth gate electrode 432.

The first, second, third, and fourth gate electrodes 131, 231, 331, and 431 and the fifth, sixth, seventh, and eighth gate electrodes 132, 232, 332, and 432 may each include a conductive material such as, for example, at least one from among TiN, WN, TaN, Ru, TiC, TaC, Ti, Ag, Al, TiAl, TiAlN, TiAlC, TaCN, TaSiN, Mn, Zr, W, Al, and a combination thereof, but embodiments of the disclosure are not limited thereto.

The first, second, third, and fourth gate electrodes 131, 231, 331, and 431, and the fifth, sixth, seventh, and eighth gate electrodes 132, 232, 332, and 432 are illustrated as being single films, but embodiments of the disclosure are not limited thereto. Alternatively, the first, second, third, and fourth gate electrodes 131, 231, 331, and 431, and the fifth, sixth, seventh, and eighth gate electrodes 132, 232, 332, and 432 may be multi-films obtained by stacking a plurality of conductive films. For example, the first, second, third, and fourth gate electrodes 131, 231, 331, and 431, and the fifth, sixth, seventh, and eighth gate electrodes 132, 232, 332, and 432 may each include a work function control film that adjusts the work function, and a filling conductive film that fills the space formed by the work function control film. The work function control film may include, for example, at least one from among TiN, TaN, TiC, TaC, TiAlC, and a combination thereof. The filling conductive film may include, for example, W or Al.

The first gate electrode 131 may serve as the gate of the first pull-up transistor PU1. For example, the region of the first active pattern A1 that intersects the first gate electrode 131 may serve as the channel region of the first pull-up transistor PU1.

The second gate electrode 231 may serve as the gate of the first pull-down transistor PD1. For example, the region of the second active pattern A2 that intersects the second gate electrode 231 may serve as the channel region of the first pull-down transistor PD1.

The fourth gate electrode 431 may serve as the gate of the first pass transistor PS1. For example, the region of the fourth active pattern A4 that intersects the fourth gate electrode 431 may serve as the channel region of the first pass transistor PS1.

The fifth gate electrode 132 may serve as the gate of the second pull-up transistor PU2. For example, the region of the first active pattern A1 that intersects the fifth gate electrode 132 may serve as the channel region of the second pull-up transistor PU2.

The sixth gate electrode 232 may serve as the gate of the second pull-down transistor PD2. For example, the region of the second active pattern A2 that intersects the sixth gate electrode 232 may serve as the channel region of the second pull-down transistor PD2.

The seventh gate electrode 332 may serve as the gate of the second pass transistor PS2. For example, the region of the third active pattern A3 that intersects the seventh gate electrode 332 may serve as the channel region of the second pass transistor PS2.

The first pull-up transistor PU1 and the second pull-up transistor PU2 may be disposed at a first level on the first surface 100a. The first pull-down transistor PD1 and the second pull-down transistor PD2 may be disposed at a second level that is higher than the first level, on the first surface 100a. The second pass transistor PS2 may be disposed at a third level that is higher than the second level, on the first surface 100a. The fourth pass transistor PS4 may be disposed at a fourth level that is higher than the third level, on the first surface 100a.

Each of the first gate structure G1 and the second gate structure G2 may include first, second, third, and fourth gate dielectric films 120, 220, 320, and 420, gate spacers 440, and a gate capping film 450.

The first, second, third, and fourth gate dielectric films 120, 220, 320, and 420 may be interposed between the first through fourth active patterns A1 through A4 and the first, second, third, and fourth gate electrodes 131, 231, 331, and 431, and between the first through fourth active patterns A1 through A4 and the fifth, sixth, seventh, and eighth gate electrodes 132, 232, 332, and 432. For example, the first gate dielectric film 120 may be interposed between the first active pattern A1 and the first gate electrode 131, and between the first active pattern A1 and the fifth gate electrode 132. For example, the second gate dielectric film 220 may be interposed between the second active pattern A2 and the second gate electrode 231, and between the second active pattern A2 and the sixth gate electrode 232. For example, the third gate dielectric film 320 may be interposed between the third active pattern A3 and the third gate electrode 331, and between the third active pattern A3 and the seventh gate electrode 332. For example, the fourth gate dielectric film 420 may be interposed between the fourth active pattern A4 and the fourth gate electrode 431, and between the fourth active pattern A4 and the eighth gate electrode 432.

The first, second, third, and fourth gate dielectric films 120, 220, 320, and 420 may each include a dielectric material such as, for example, at least one from among silicon oxide, silicon oxynitride, silicon nitride, and a high-k dielectric material having a greater dielectric constant than silicon oxide. The high-k dielectric material may include, for example, at least one from among hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalate, lead zinc niobate, and a combination thereof, but embodiments of the disclosure are not limited thereto.

The first, second, third, and fourth gate dielectric films 120, 220, 320, and 420 are illustrated as being single films, but embodiments of the disclosure are not limited thereto. Alternatively, the first, second, third, and fourth gate dielectric films 120, 220, 320, and 420 may be multi-films formed by stacking a plurality of dielectric films. For example, the first, second, third, and fourth gate dielectric films 120, 220, 320, and 420 may each include an interface film and a high-k dielectric film that are sequentially stacked on the first through fourth active patterns A1 through A4. The interface film may include, for example, an oxide film formed by oxidizing the surfaces of the first through fourth active patterns A1 through A4. The high-k dielectric film may include, for example, a high-k dielectric material having a greater dielectric constant than silicon oxide.

In one or more embodiments, part of the first gate dielectric film 120 may extend along the first surface 100a of the substrate 100. In one or more embodiments, part of the second gate dielectric film 220 may extend along the upper surface of a first gate separation pattern 515. In one or more embodiments, part of the third gate dielectric film 320 may extend along the upper surface of a second gate separation pattern 525. In one or more embodiments, part of the fourth gate dielectric film 420 may extend along the upper surface of a third gate separation pattern 535.

The gate spacers 440 may extend along the sidewalls of the first, second, third, and fourth gate electrodes 131, 231, 331, and 431, and the sidewalls of the fifth, sixth, seventh, and eighth gate electrodes 132, 232, 332, and 432. Each of the first through fourth active patterns A1 through A4 may extend in the first direction X and penetrate the gate spacers 440. The gate spacers 440 may include an insulating material such as, for example, at least one from among silicon oxide, silicon nitride, silicon oxynitride, silicon oxycarbide, silicon boron nitride, silicon boron carbonitride, silicon oxycarbonitride, and a combination thereof, but embodiments of the disclosure are not limited thereto.

In one or more embodiments, parts of the first, second, third, and fourth gate dielectric films 120, 220, 320, and 420 may extend further along the inner sidewalls of the gate spacers 440.

The gate capping film 450 may extend along the upper surface of the fourth gate electrode 431. The gate capping film 450 may include an insulating material, for example, at least one of silicon oxide, silicon nitride, silicon oxynitride, silicon oxycarbide, silicon boron nitride, silicon boron carbonitride, silicon oxycarbonitride, and a combination thereof, but embodiments of the disclosure are not limited thereto.

In one or more embodiments, each of the first gate structure G1 and the second gate structure G2 may include the first gate separation pattern 515. The first gate separation pattern 515 may be interposed between the first gate electrode 131 and the second gate electrode 231, and between the fifth and sixth gate electrodes 132 and 232. The first gate separation pattern 515 may extend in the second direction Y. The first gate separation pattern 515 may separate the first gate electrode 131 from the second gate electrode 231, and the fifth gate electrode 132 from the sixth gate electrode 232.

In one or more embodiments, each of the first gate structure G1 and the second gate structure G2 may include the second gate separation pattern 525. The second gate separation pattern 525 may be interposed between the second gate electrode 231 and the third gate electrode 331, and between the sixth and seventh gate electrodes 232 and 332. The second gate separation pattern 525 may extend in the second direction Y. The second gate separation pattern 525 may separate the second gate electrode 231 from the third gate electrode 331, and the sixth gate electrode 232 from the seventh gate electrode 332.

In one or more embodiments, each of the first gate structure G1 and the second gate structure G2 may include the third gate separation pattern 535. The third gate separation pattern 535 may be interposed between the third gate electrode 331 and the fourth gate electrode 431, and between the seventh gate electrode 332 and the eighth gate electrode 432. The third gate separation pattern 535 may extend in the second direction Y. The third gate separation pattern 535 may separate the third gate electrode 331 from the fourth gate electrode 431, and the seventh gate electrode 332 from the eighth gate electrode 432.

The first, second, and third gate separation patterns 515, 525, and 535 may each include an insulating material such as, for example, at least one from among silicon oxide, silicon nitride, silicon oxynitride, silicon oxycarbide, silicon boron nitride, silicon boron carbonitride, silicon oxycarbonitride, and a combination thereof, but embodiments of the disclosure are not limited thereto.

The first-level source/drain patterns (e.g., the first through third source/drain patterns 161 through 163) may be formed within the first active pattern A1 on the sidewalls of the first gate structure G1 and the second gate structure G2. The first active pattern A1 may extend through the first gate structure G1 and the second gate structure G2 and be connected to the first-level source/drain patterns (e.g., the first through third source/drain patterns 161 through 163). The first-level source/drain patterns (e.g., the first through third source/drain patterns 161 through 163) may be separated from the first and fifth gate electrodes 131 and 132 by the gate spacers 440 and/or the first gate dielectric film 120.

The first-level source/drain patterns may include the first source/drain pattern 161, the second source/drain pattern 162, and the third source/drain pattern 163. The first source/drain pattern 161 may be interposed between the first gate electrode 131 and the fifth gate electrode 132. The first gate electrode 131 may be interposed between the first source/drain pattern 161 and the second source/drain pattern 162. The fifth gate electrode 132 may be interposed between the first source/drain pattern 161 and the third source/drain pattern 163.

In one or more embodiments, the first-level source/drain patterns (e.g., the first through third source/drain patterns 161 through 163) may each include an epitaxial layer doped with impurities. For example, the first-level source/drain patterns (e.g., the first through third source/drain patterns 161 through 163) may include epitaxial patterns grown by an epitaxial growth method from the first active pattern A1.

If the first active pattern A1 serves as the channel region of a PFET, the first-level source/drain patterns (e.g., the first through third source/drain patterns 161 through 163) may each include p-type impurities (e.g., B, In, Ga, or Al) or impurities to prevent the diffusion of the p-type impurities.

The second-level source/drain patterns (e.g., the fourth through sixth source/drain patterns 261 through 263) may be formed within the second active pattern A2 on the sidewalls of the first gate structure G1 and the second gate structure G2. The second active pattern A2 may extend through the first gate structure G1 and the second gate structure G2 and be connected to the second-level source/drain patterns (e.g., the fourth through sixth source/drain patterns 261 through 263). The second-level source/drain patterns (e.g., the fourth through sixth source/drain patterns 261 through 263) may be separated from the second and sixth gate electrodes 231 and 232 by the gate spacers 440 and/or the second gate dielectric film 220.

The second-level source/drain patterns (e.g., the fourth through sixth source/drain patterns 261 through 263) may include the fourth source/drain pattern 261, the fifth source/drain pattern 262, and the sixth source/drain pattern 263. The fourth source/drain pattern 261 may be interposed between the second gate electrode 231 and the sixth gate electrode 232. The second gate electrode 231 may be interposed between the fourth source/drain pattern 261 and the fifth source/drain pattern 262. The sixth gate electrode 232 may be interposed between the fourth source/drain pattern 261 and the sixth source/drain pattern 263.

In one or more embodiments, the second-level source/drain patterns (e.g., the fourth through sixth source/drain patterns 261 through 263) may each include an epitaxial layer doped with impurities. For example, the second-level source/drain patterns (e.g., the fourth through sixth source/drain patterns 261 through 263) may include epitaxial patterns grown by an epitaxial growth method from the second active pattern A2.

If the second active pattern A2 serves as the channel region of an NFET, the second-level source/drain patterns (e.g., the fourth through sixth source/drain patterns 261 through 263) may each include n-type impurities (e.g., B, In, Ga, or Al) or impurities to prevent the diffusion of the n-type impurities.

The third-level source/drain patterns (e.g., the seventh source/drain pattern 361 and the eighth source/drain pattern 363) may be formed within the third active pattern A3 on the sidewalls of the first gate structure G1 and the second gate structure G2. The third active pattern A3 may extend through the first gate structure G1 and the second gate structure G2 and be connected to the third-level source/drain patterns (e.g., the seventh source/drain pattern 361 and the eighth source/drain pattern 363). The third-level source/drain patterns (e.g., the seventh source/drain pattern 361 and the eighth source/drain pattern 363) may be separated from the third gate electrode 331 and the seventh gate electrode 332 by the gate spacers 440 and/or the third gate dielectric film 320.

The third-level source/drain patterns (e.g., the seventh source/drain pattern 361 and the eighth source/drain pattern 363) may include the seventh source/drain pattern 361 and the eighth source/drain pattern 363. The seventh source/drain pattern 361 may be interposed between the third gate electrode 331 and the seventh gate electrode 332. The seventh gate electrode 332 may be interposed between the seventh source/drain pattern 361 and the eighth source drain/pattern 363.

In one or more embodiments, the third-level source/drain patterns (e.g., the seventh source/drain pattern 361 and the eighth source/drain pattern 363) may each include an epitaxial layer doped with impurities. For example, the third-level source/drain patterns (e.g., the seventh source/drain pattern 361 and the eighth source/drain pattern 363) may include epitaxial patterns grown by an epitaxial growth method from the third active pattern A3.

If the third active pattern A3 serves as the channel region of an NFET, the third-level source/drain patterns (e.g., the seventh source/drain pattern 361 and the eighth source/drain pattern 363) may each include n-type impurities (e.g., B, In, Ga, or Al) or impurities to prevent the diffusion of the n-type impurities.

The fourth-level source/drain patterns (e.g., the ninth source/drain pattern 461 and the tenth source/drain pattern 462) may be formed within the fourth active pattern A4 on the sidewalls of the first gate structure G1 and the second gate structure G2. The fourth active pattern A4 may extend through the first gate structure G1 and the second gate structure G2 and be connected to the fourth-level source/drain patterns (e.g., the ninth source/drain pattern 461 and the tenth source/drain pattern 462). The fourth-level source/drain patterns (e.g., the ninth source/drain pattern 461 and the tenth source/drain pattern 462) may be separated from the fourth gate electrode 431 and the eighth gate electrode 432 by the gate spacers 440 and/or the fourth gate dielectric film 420.

The fourth-level source/drain patterns (e.g., the ninth source/drain pattern 461 and the tenth source/drain pattern 462) may include the ninth source/drain pattern 461 and the tenth source/drain pattern 462. The ninth source/drain pattern 461 may be interposed between the fourth and eighth gate electrodes 431 and 432. The fourth gate electrode 431 may be interposed between the ninth source/drain pattern 461 and the tenth source/drain pattern 462.

In one or more embodiments, the fourth-level source/drain patterns (e.g., the ninth source/drain pattern 461 and the tenth source/drain pattern 462) may each include an epitaxial layer doped with impurities. For example, the fourth-level source/drain patterns (e.g., the ninth source/drain pattern 461 and the tenth source/drain pattern 462) may include epitaxial patterns grown by an epitaxial growth method from the fourth active pattern A4.

If the fourth active pattern A4 serves as the channel region of an NFET, the fourth-level source/drain patterns (e.g., the ninth source/drain pattern 461 and the tenth source/drain pattern 462) may each include n-type impurities (e.g., B, In, Ga, or Al) or impurities to prevent the diffusion of the n-type impurities.

The first, second, third, and fourth interlayer insulating films 190, 290, 390, and 490 may be formed on the substrate 100. The first, second, third, and fourth interlayer insulating films 190, 290, 390, and 490 may be sequentially stacked on the first surface 100a. The first, second, third, and fourth interlayer insulating films 190, 290, 390, and 490 may fill the spaces on the sidewalls of the first gate structure G1 and the second gate structure G2.

The first interlayer insulating film 190 may be formed on the first surface 100a. The first interlayer insulating film 190 may cover the first-level source/drain patterns (e.g., the first through third source/drain patterns 161 through 163). The second interlayer insulating film 290 may be formed on the first interlayer insulating film 190. The second interlayer insulating film 290 may cover the second-level source/drain patterns (e.g., the fourth through sixth source/drain patterns 261 through 263). The third interlayer insulating film 390 may be formed on the second interlayer insulating film 290. The third interlayer insulating film 390 may cover the third-level source/drain patterns (e.g., the seventh source/drain pattern 361 and the eighth source/drain pattern 363). The fourth interlayer insulating film 490 may be formed on the third interlayer insulating film 390. The fourth interlayer insulating film 490 may cover the fourth-level source/drain patterns (e.g., the ninth source/drain pattern 461 and the tenth source/drain pattern 462).

The first, second, third, and fourth interlayer insulating films 190, 290, 390, and 490 may each include, for example, at least one from among silicon oxide, silicon nitride, silicon oxynitride, silicon oxycarbide, silicon boron nitride, silicon boron carbon nitride, silicon oxycarbonitride, and a low-k dielectric material with a less dielectric constant than silicon oxide, but embodiments of the disclosure are not limited thereto.

In one or more embodiments, the third-level source/drain patterns (e.g., the seventh source/drain pattern 361 and the eighth source/drain pattern 363) may not overlap with the tenth source/drain pattern 462 in the third direction Z. For example, the seventh source/drain pattern 361 may be connected to the third active pattern A3 on one side of the third gate electrode 331, and part of the third interlayer insulating film 390 may fill the area on the opposite side of the third gate electrode 331.

In one or more embodiments, the fourth-level source/drain patterns (e.g., the ninth source/drain pattern 461 and the tenth source/drain pattern 462) may not overlap with the eighth source/drain pattern 363 in the third direction Z. For example, the ninth source/drain pattern 461 may be connected to the fourth active pattern A4 on one side of the eighth gate electrode 432, and part of the fourth interlayer insulating film 490 may fill the area on the opposite side of the eighth gate electrode 432.

The frontside source/drain contacts (e.g., the first frontside source/drain contact CA4 and the second frontside source/drain contact CA3) may each be disposed on the first surface 100a. The frontside source/drain contacts (e.g., the first frontside source/drain contact CA4 and the second frontside source/drain contact CA3) may each extend in the third direction Z and be connected to the first through fourth active patterns A1 through A4. The number, shape, and arrangement of the frontside source/drain contacts (e.g., the first frontside source/drain contact CA4 and the second frontside source/drain contact CA3) are merely an example and are not particularly limited.

In one or more embodiments, the frontside source/drain contacts (e.g., the first frontside source/drain contact CA4 and the second frontside source/drain contact CA3) may include the first frontside source/drain contact CA4 and the second frontside source/drain contact CA3.

The first frontside source/drain contact CA4 may be interposed between the first gate structure G1 and the second gate structure G2. The first frontside source/drain contact CA4 may be connected to the ninth source/drain pattern 461. For example, the first frontside source/drain contact CA4 may penetrate the fourth interlayer insulating film 490 and be connected to the upper surface of the ninth source/drain pattern 461.

The second gate structure G2 may be interposed between the first frontside source/drain contact CA4 and the second frontside source/drain contact CA3. The second frontside source/drain contact CA3 may be connected to the eighth source/drain pattern 363. For example, the second frontside source/drain contact CA3 may penetrate the fourth interlayer insulating film 490 and the third interlayer insulating film 390 and be connected to the upper surface of the eighth source/drain pattern 363.

The frontside wiring structure FW may be formed on the first surface 100a. For example, a fifth interlayer insulating film 495 may be formed to cover the fourth interlayer insulating film 490. The frontside wiring structure FW may be formed on the fifth interlayer insulating film 495. The frontside wiring structure FW may include a frontside wiring insulating film FD that covers the fifth interlayer insulating film 495, and frontside wiring patterns (e.g., first through third frontside wiring patterns FM11 through FM13 and a fourth frontside wiring pattern FM2) within the frontside wiring insulating film FD. The frontside wiring patterns (e.g., the first through third frontside wiring patterns FM11 through FM13 and the fourth frontside wiring pattern FM2) may be spaced apart and insulated from one another by the frontside wiring insulating film FD. The number, shape, and arrangement of the frontside wiring patterns (e.g., the first through third frontside wiring patterns FM11 through FM13 and the fourth frontside wiring pattern FM2) are merely an example and are not particularly limited.

In one or more embodiments, the frontside wiring patterns may include a first frontside wiring pattern FM11, a second frontside wiring pattern FM12, a third frontside wiring pattern FM13, and a fourth frontside wiring pattern FM2.

The first, second, and third frontside wiring patterns FM11, FM12, and FM13 may each extend in the first direction X. The first, second, and third frontside wiring patterns FM11, FM12, and FM13 may be arranged along the second direction Y. In one or more embodiments, the first, second, and third frontside wiring patterns FM11, FM12, and FM13 may be disposed at the same level. Here, "disposed at the same level" means that the first, second, and third frontside wiring patterns FM11, FM12, and FM13 are positioned at the same height relative to the substrate 100. In one or more embodiments, the first frontside wiring pattern FM11 may be interposed between the second frontside wiring pattern FM12 and the third frontside wiring pattern FM13 in the second direction Y.

The first frontside wiring pattern FM11 may be connected to the first frontside source/drain contact CA4. For example, a first contact via VA1 may be formed to penetrate the fifth interlayer insulating film 495 and connect the first frontside source/drain contact CA4 and the first frontside wiring pattern FM11. The first frontside wiring pattern FM11 may be provided as a bitline BL and may be connected to the first pass transistor PS1 through the first frontside source/drain contact CA4.

The second frontside wiring pattern FM12 may be connected to the second frontside source/drain contact CA3. For example, a second contact via VA2 may be formed to penetrate the fifth interlayer insulating film 495 and connect the second frontside source/drain contact CA3 and the second frontside wiring pattern FM12. The second frontside wiring pattern FM12 may be provided as a complementary bitline /BL and may be connected to the second pass transistor PS2 through the second frontside source/drain contact CA3.

The third frontside wiring pattern FM13 may be connected to the fourth gate electrode 431 and the seventh gate electrode 332. For example, a first frontside gate contact CB1 may be formed to penetrate the fifth interlayer insulating film 495 and the gate capping film 450 and connect the fourth gate electrode 431 and the third frontside wiring pattern FM13. Additionally, for example, a second frontside gate contact CB2 may be formed to penetrate the fifth interlayer insulating film 495, the gate capping film 450, and the third gate separation pattern 535 and connect the seventh gate electrode 332 and the third frontside wiring pattern FM13.

The fourth frontside wiring pattern FM2 may extend in the second direction Y. In one or more embodiments, the fourth frontside wiring pattern FM2 may be disposed at a higher level than the first through third frontside wiring patterns FM11 through FM13. The fourth frontside wiring pattern FM2 may be connected to the third frontside wiring pattern FM13. For example, a frontside via FV may be formed to extend in the third direction Z and connect the third frontside wiring pattern FM13 and the fourth frontside wiring pattern FM2. The fourth frontside wiring pattern FM2 may be provided as a wordline WL and may be connected to the gate of the first pass transistor PS1, i.e., the fourth gate electrode 431, and the gate of the second pass transistor PS2, i.e., the seventh gate electrode 332.

The backside source/drain contacts (e.g., the first through seventh backside source/drain contacts BCA11, BCA12, BCA13, BCA21, BCA22, BCA3, and BCA4) may each penetrate the substrate 100. The backside source/drain contacts (e.g., the first through seventh backside source/drain contacts BCA11, BCA12, BCA13, BCA21, BCA22, BCA3, and BCA4) may each extend in the third direction Z and be connected to the first through fourth active patterns A1 through A4. The number, shape, and arrangement of the backside source/drain contacts (e.g., the first through seventh backside source/drain contacts BCA11, BCA12, BCA13, BCA21, BCA22, BCA3, and BCA4) are merely an example and are not particularly limited.

In one or more embodiments, the backside source/drain contacts (e.g., the first through seventh backside source/drain contacts BCA11, BCA12, BCA13, BCA21, BCA22, BCA3, and BCA4) may include a first backside source/drain contact BCA11, a second backside source/drain contact BCA12, a third backside source/drain contact BCA13, a fourth backside source/drain contact BCA21, a fifth backside source/drain contact BCA22, a sixth backside source/drain contact BCA3, and a seventh backside source/drain contact BCA4.

The first backside source/drain contact BCA11 may be interposed between the first gate structure G1 and the second gate structure G2. The first backside source/drain contact BCA11 may be connected to the first source/drain pattern 161. For example, the first backside source/drain contact BCA11 may penetrate the substrate 100 and be connected to the lower surface of the first source/drain pattern 161.

The first gate structure G1 may be interposed between the first backside source/drain contact BCA11 and the second backside source/drain contact BCA12. The second backside source/drain contact BCA12 may be connected to the second source/drain pattern 162. For example, the second backside source/drain contact BCA12 may penetrate the substrate 100 and be connected to the lower surface of the second source/drain pattern 162.

The second gate structure G2 may be interposed between the first backside source/drain contact BCA11 and the third backside source/drain contact BCA13. The third backside source/drain contact BCA13 may be connected to the third source/drain pattern 163. For example, the third backside source/drain contact BCA13 may penetrate the substrate 100 and be connected to the lower surface of the third source/drain pattern 163.

The fourth backside source/drain contact BCA21 may be interposed between the first gate structure G1 and the second gate structure G2. The fourth backside source/drain contact BCA21 may be connected to the fourth source/drain pattern 261.

In one or more embodiments, the fourth source/drain pattern 261 may include a first base portion 261a and a first extension portion 261b. The first base portion 261a may overlap with the first source/drain pattern 161 in the third direction Z. The first extension portion 261b may extend from the first base portion 261a in the second direction Y. The first extension portion 261b may not overlap with the first source/drain pattern 161 in the third direction Z. The fourth backside source/drain contact BCA21 may extend in the third direction Z and contact the first extension portion 261b. The first backside source/drain contact BCA11 and the fourth backside source/drain contact BCA21 may be arranged along the second direction Y.

The second gate structure G2 may be interposed between the fourth backside source/drain contact BCA21 and the fifth backside source/drain contact BCA22. The fifth backside source/drain contact BCA22 may be connected to the sixth source/drain pattern 263.

In one or more embodiments, the sixth source/drain pattern 263 may include a second base portion 263a and a second extension portion 263b. The second base portion 263a may overlap with the third source/drain pattern 163 in the third direction Z. The second extension portion 263b may extend from the second base portion 263a in the second direction Y. The second extension portion 263b may not overlap with the third source/drain pattern 163 in the third direction Z. The fifth backside source/drain contact BCA22 may extend in the third direction Z and contact the second extension portion 263b. The third backside source/drain contact BCA22 and the fifth backside source/drain contact BCA22 may be arranged along the second direction Y.

The sixth backside source/drain contact BCA3 may be interposed between the first gate structure G1 and the second gate structure G2. The sixth backside source/drain contact BCA3 may be connected to the seventh source/drain pattern 361.

In one or more embodiments, the seventh source/drain pattern 361 may include a third base portion 361a and a third extension portion 361b. The third base portion 361a may overlap with the first base portion 261a in the third direction Z. The third extension portion 361b may extend from the third base portion 361a in the second direction Y. The third extension portion 361b may not overlap with the first base portion 261a or the first extension portion 261b in the third direction Z. The sixth backside source/drain contact BCA3 may extend in the third direction Z and contact the third extension portion 361b. The first backside source/drain contact BCA11 may be interposed between the fourth backside source/drain contact BCA21 and the sixth backside source/drain contact BCA3 in the second direction Y.

The first gate structure G1 may be interposed between the fourth backside source/drain contact BCA21 and the seventh backside source/drain contact BCA4. The seventh backside source/drain contact BCA4 may be connected to the fifth source/drain pattern 262 and the tenth source/drain pattern 462.

In one or more embodiments, the fifth source/drain pattern 262 may include a fourth base portion 262a and a fourth extension portion 262b. The fourth base portion 262a may overlap with the second source/drain pattern 162 in the third direction Z. The fourth extension portion 262b may extend from the fourth base portion 262a in the second direction Y. The fourth extension portion 262b may not overlap with the second source/drain pattern 162 in the third direction Z. The seventh backside source/drain contact BCA4 may extend in the third direction Z and contact the fourth extension portion 262b. The second backside source/drain contact BCA12 and the seventh backside source/drain contact BCA4 may be arranged along the second direction Y.

In one or more embodiments, the tenth source/drain pattern 462 may include a fifth base portion 462a and a fifth extension portion 462b. The fifth base portion 462a may overlap with the fourth base portion 262a in the third direction Z. The fifth extension portion 462b may extend from the fifth base portion 462a in the second direction Y. The fifth extension portion 462b may overlap with the fourth extension portion 262b in the third direction Z. The seventh backside source/drain contact BCA4 may extend in the third direction Z and contact both the fourth extension portion 262b and the fifth extension portion 462b.

The backside wiring structure BW may be formed on the second surface 100b. The backside wiring structure BW may include a backside wiring insulating film BD that covers the second surface 100b, and backside wiring patterns (e.g., a first connection wiring pattern BM11, a second connection wiring pattern BM12, a first backside wiring pattern BM21, and a second backside wiring pattern BM22) within the backside wiring insulating film BD. The backside wiring patterns (e.g., the first connection wiring pattern BM11, the second connection wiring pattern BM12, the first backside wiring pattern BM21, and the second backside wiring pattern BM22) may be spaced apart and insulated from one another by the backside wiring insulating film BD. The number, shape, and arrangement of the backside wiring patterns (e.g., the first connection wiring pattern BM11, the second connection wiring pattern BM12, the first backside wiring pattern BM21, and the second backside wiring pattern BM22) are merely an example and are not particularly limited.

In one or more embodiments, the backside wiring patterns may include a first connection wiring pattern BM11, a second connection wiring pattern BM12, a first backside wiring pattern BM21, and a second backside wiring pattern BM22.

The first connection wiring pattern BM11 and the second connection wiring pattern BM12 may be disposed on the second surface 100b. In one or more embodiments, the first connection wiring pattern BM11 and the second connection wiring pattern BM12 may be disposed at the same level.

The first connection wiring pattern BM11 may be connected to the second backside source/drain contact BCA12, the seventh backside source/drain contact BCA4, the fifth gate electrode 132, and the sixth gate electrode 232. For example, a first backside gate contact BCB2 may be formed to penetrate the substrate 100 and the first gate separation pattern 515 and be connected to the fifth gate electrode 132 and the sixth gate electrode 232. The first connection wiring pattern BM11 may connect the second backside source/drain contact BCA12, the seventh backside source/drain contact BCA4, and the first backside gate contact BCB2. Through this, the first connection wiring pattern BM11 may connect the output node N1 of the first inverter INV1 to the input node of the second inverter INV2, i.e., the fifth gate electrode 132 and the sixth gate electrode 232.

The second connection wiring pattern BM12 may be connected to the third, fifth, and sixth backside source/drain contacts BCA13, BCA22, BCA3 and the first gate electrode 131 and the second gate electrode 231. For example, a second backside gate contact BCB1 may be formed to penetrate the substrate 100 and the first gate separation pattern 515 and be connect to the first gate electrode 131 and the second gate electrode 231. The second connection wiring pattern BM12 may connect the third, fifth, and sixth backside source/drain contacts BCA13, BCA22, and BCA3 and the second backside gate contact BCB1. Through this, the second connection wiring pattern BM12 may connect the output node N2 of the second inverter INV2 to the input node of the first inverter INV1, i.e., the first gate electrode 131 and the second gate electrode 231.

The first backside wiring pattern BM21 and the second backside wiring pattern BM22 may each extend longitudinally in the first direction X. The first backside wiring pattern BM21 and the second backside wiring pattern BM22 may be arranged along the second direction Y. In one or more embodiments, the first backside wiring pattern BM21 and the second backside wiring pattern BM22 may be disposed at the same level. In one or more embodiments, the first backside wiring pattern BM21 and the second backside wiring pattern BM22 may be disposed at a higher level than the first connection wiring pattern BM11 and the second connection wiring pattern BM12.

The first backside wiring pattern BM21 may be connected to the first backside source/drain contact BCA11. For example, a first backside via BV1 may be formed to extend in the third direction Z and connect the first backside source/drain contact BCA11 and the first backside wiring pattern BM21. The first backside wiring pattern BM21 may be provided as a first power supply line for applying a first power supply voltage (e.g., V_{DD}) to the first pull-up transistor PU1 and the second pull-up transistor PU2.

The second backside wiring pattern BM22 may be connected to the fourth backside source/drain contact BCA21. For example, a second backside via BV2 may be formed to extend in the third direction Z and connect the fourth backside source/drain contact BCA21 and the second backside wiring pattern BM22. The second backside wiring pattern BM22 may be provided as a second power supply line for applying a second power supply voltage (e.g., V_{SS}), which is different from the first power voltage, to the first pull-down transistor PD1 and the second pull-down transistor PD2.

A method for manufacturing a semiconductor device according to example embodiments will hereinafter be described with reference to FIGS. 1 through 39.

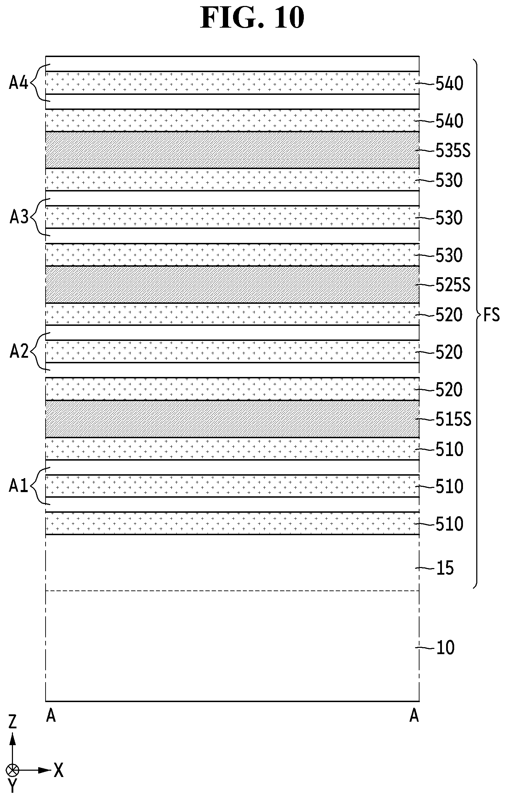

FIGS. 10 through 39 are cross-sectional views for explaining a method for manufacturing a semiconductor device according to one or more embodiments. For convenience of explanation, content that overlaps with what has been described above with reference to FIGS. 1 through 9 may be briefly explained or omitted.

Referring to FIG. 10, a fin structure FS is formed on a base substrate 10.

The fin structure FS may extend in the first direction X. The fin structure FS may include a fin pattern 15, first through fourth active patterns A1 through A4, first through fourth sacrificial patterns 510, 520, 530, and 540, and first through third sacrificial separation patterns 515S, 525S, and 535S.

The fin pattern 15 may protrude from the upper surface of the base substrate 10 and extend in the first direction X. The first active pattern A1 and the first sacrificial pattern 510 may be alternately stacked on the fin pattern 15. The first sacrificial separation pattern 515S may be stacked on the first active pattern A1 and the first sacrificial pattern 510. The second active pattern A2 and the second sacrificial pattern 520 may be alternately stacked on the first sacrificial separation pattern 515S. The second sacrificial separation pattern 525S may be stacked on the second active pattern A2 and the second sacrificial pattern 520. The third active pattern A3 and the third sacrificial pattern 530 may be alternately stacked on the second sacrificial separation pattern 525S. The third sacrificial separation pattern 535S may be stacked on the third active pattern A3 and the third sacrificial pattern 530. The fourth active pattern A4 and the fourth sacrificial pattern 540 may be alternately stacked on the third sacrificial separation pattern 535S.

The first, second, third, and fourth sacrificial patterns 510, 520, 530, and 540 may each include a material that has an etch selectivity with respect to the first through fourth active patterns A1 through A4. For example, the first through fourth active patterns A1 through A4 may each include an Si film, and the first, second, third, and fourth sacrificial patterns 510, 520, 530, and 540 may each include an SiGe film.

The first, second, and third sacrificial separation patterns 515S, 525S, and 535S may each include a material that has an etch selectivity with respect to the first through fourth active patterns A1 through A4 and the first, second, third, and fourth sacrificial patterns 510, 520, 530, and 540. For example, the first, second, third, and fourth sacrificial patterns 510, 520, 530, and 540 may each include an SiGe film containing a first concentration of Ge, and the first, second, and third sacrificial separation patterns 515S, 525S, and 535S may each include an SiGe film containing a second concentration of Ge that is higher than the first concentration.

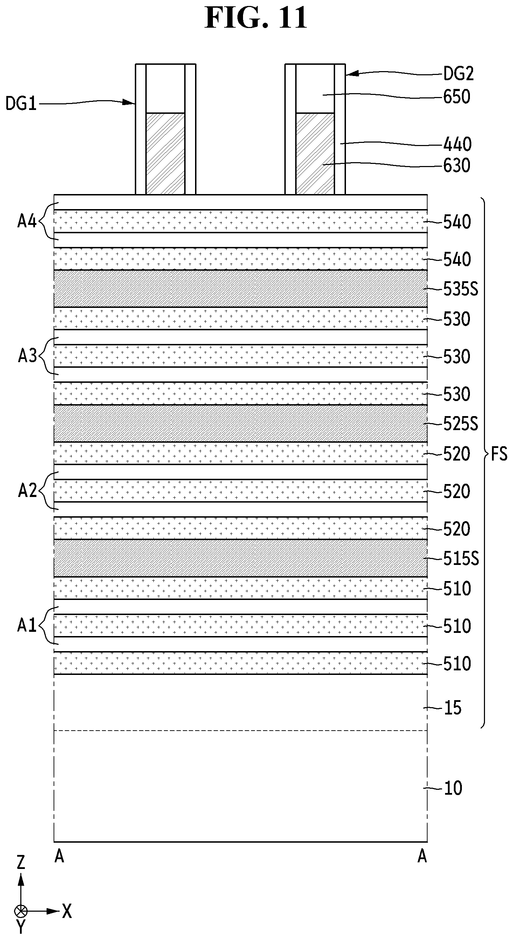

Referring to FIG. 11, a first dummy gate structure DG1 and a second dummy gate structure DG2 are formed on the fin structure FS.

The first dummy gate structure DG1 and the second dummy gate structure DG2 may be spaced apart from each other and intersect the fin structure FS. For example, the first dummy gate structure DG1 and the second dummy gate structure DG2 may be spaced apart from each other in the first direction X and may each extend longitudinally in a second direction Y.

Each of the first dummy gate structure DG1 and the second dummy gate structure DG2 may include a dummy gate electrode 630, gate spacers 440, and a first mask pattern 650. For example, a material film may be formed on the fin structure FS. Thereafter, the first mask pattern 650, which extends in parallel in the second direction Y, may be formed on the material film. Thereafter, using the first mask pattern 650 as an etching mask, a patterning process may be performed on the material film to form the dummy gate electrode 630. Thereafter, the gate spacers 440, which extend along the sidewalls of the dummy gate electrode 630, may be formed.

The dummy gate electrode 630 may include a material having an etch selectivity with respect to the first through fourth active patterns A1 through A4. For example, the dummy gate electrode 630 may include a polysilicon film.

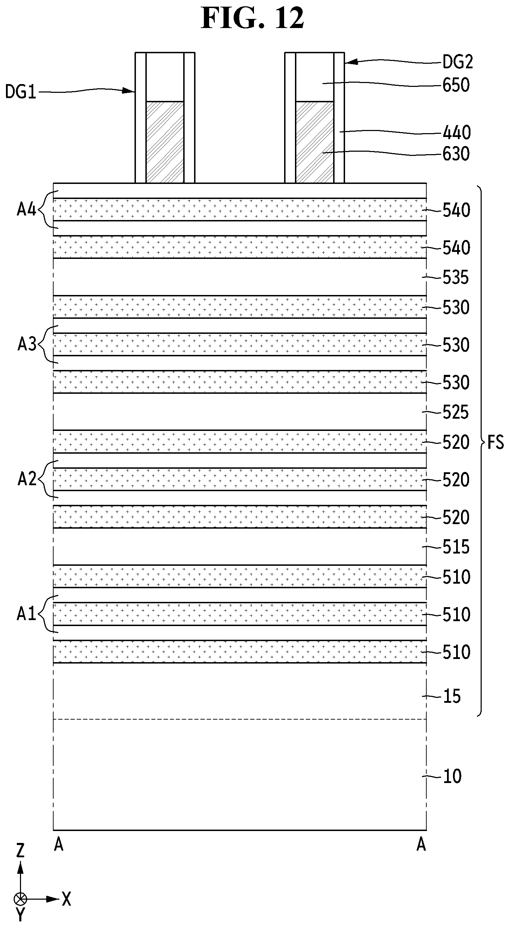

Referring to FIG. 12, the first, second, and third gate separation patterns 515, 525, and 535 are formed.

For example, the first, second, and third sacrificial separation patterns 515S, 525S, and 535S may be selectively removed. Thereafter, the first, second, and third gate separation patterns 515, 525, and 535, which replace the removed first through third sacrificial separation patterns 515S, 525S, and 535S, respectively, may be formed. Through this, the fin structure FS, which includes the fin pattern 15, the first through fourth active patterns A1 through A4, the first, second, third, and fourth sacrificial patterns 510, 520, 530, 540, and the first, second, and third gate separation patterns 515, 525, 535, may be formed.

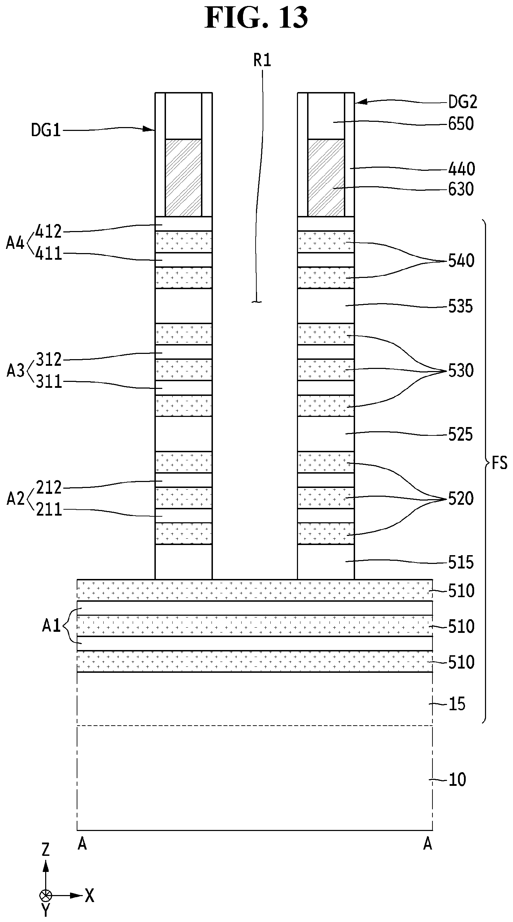

Referring to FIG. 13, a recess process is performed on the fin structure FS using the first dummy gate structure DG1 and the second dummy gate structure DG2.

As the recess process is performed, first recesses R1 may be formed within the second through fourth active patterns A2 through A4, the second, third, and fourth sacrificial patterns 520, 530, and 540, and the first, second, and third gate separation patterns 515, 525, and 535.

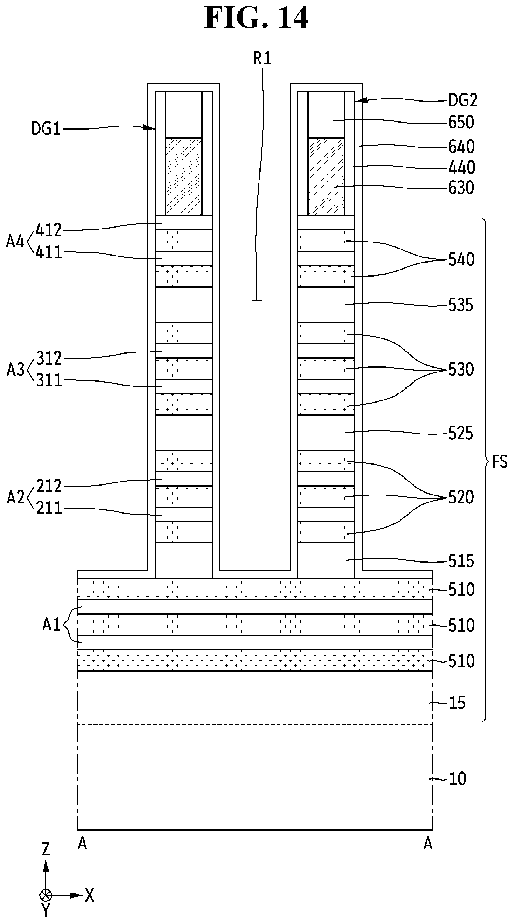

Referring to FIG. 14, a first liner film 640 is formed.

The first liner film 640 may be formed over the result from FIG. 13. For example, the first liner film 640 may conformally extend along the profile of the first recesses R1. The first liner film 640 may include an insulating material such as, for example, at least one from among silicon oxide, silicon nitride, silicon oxynitride, silicon oxycarbide, silicon boron nitride, silicon boron carbonitride, silicon oxycarbonitride, and a combination thereof, but embodiments of the disclosure are not limited thereto.

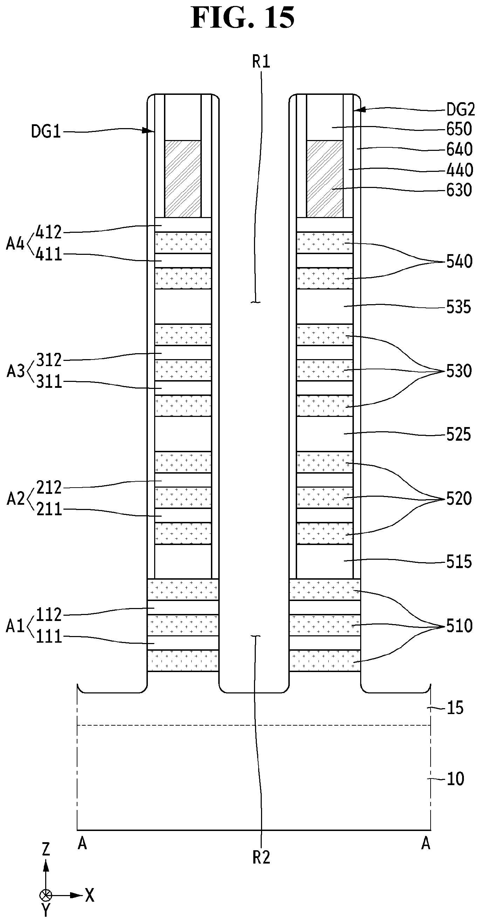

Referring to FIG. 15, a recess process is performed on the first active pattern A1 and the first sacrificial pattern 510 using the first liner film 640.

As the recess process is performed, second recesses R2 may be formed within the first active pattern A1 and the first sacrificial pattern 510. In one or more embodiments, the bottom surfaces of the second recesses R2 may be formed lower than the upper surface of the fin structure FS.

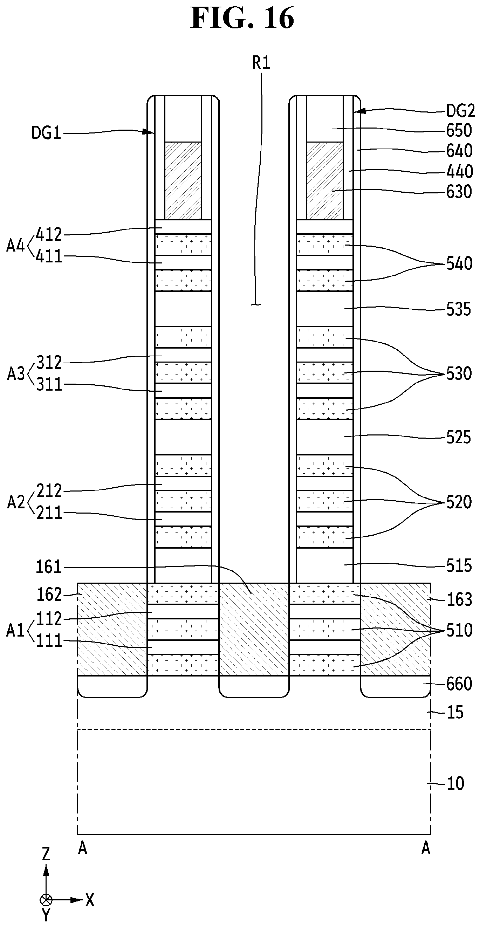

Referring to FIG. 16, first-level source/drain patterns (e.g., the first through third source/drain patterns 161 through 163) are formed.

The first-level source/drain patterns (e.g., the first through third source/drain patterns 161 through 163) may be formed through an epitaxial growth process that uses the first active pattern A1 as a seed layer. Through this, the first-level source/drain patterns (e.g., the first through third source/drain patterns 161 through 163), which are connected to the first active pattern A1, may be formed.

In one or more embodiments, a holder pattern 660 may be formed within the fin structure FS. The first-level source/drain patterns (e.g., the first through third source/drain patterns 161 through 163) may be formed on the holder pattern 660. The holder pattern 660 may include a material having an etch selectivity with respect to the base substrate 10 and the fin pattern 15. For example, the base substrate 10 and the fin pattern 15 may each include an Si film, and the holder pattern 660 may include an SiGe film. In one or more embodiments, the holder pattern 660 may be omitted.

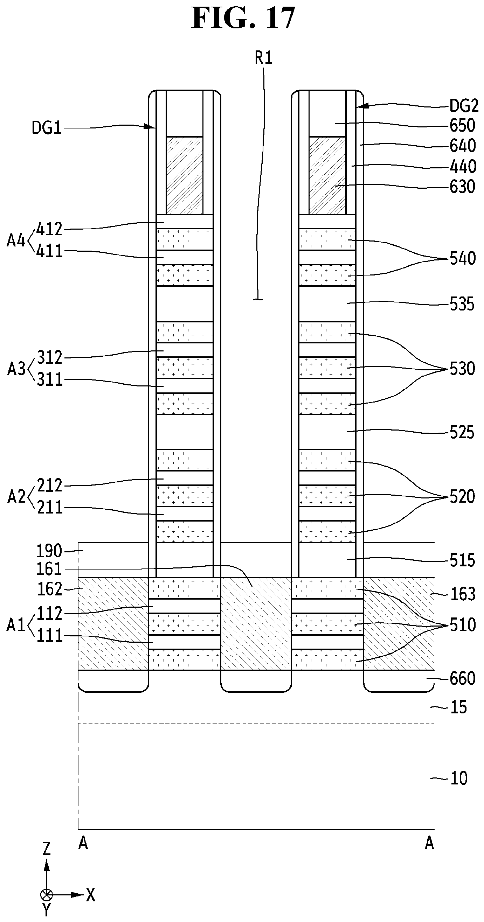

Referring to FIG. 17, a first interlayer insulating film 190 is formed on the first-level source/drain patterns (e.g., the first through third source/drain patterns 161 through 163).

The first interlayer insulating film 190 may cover the first-level source/drain patterns (e.g., the first through third source/drain patterns 161 through 163). In one or more embodiments, the upper surface of the first interlayer insulating film 190 may be formed lower than the lower surface of the second active pattern A2.

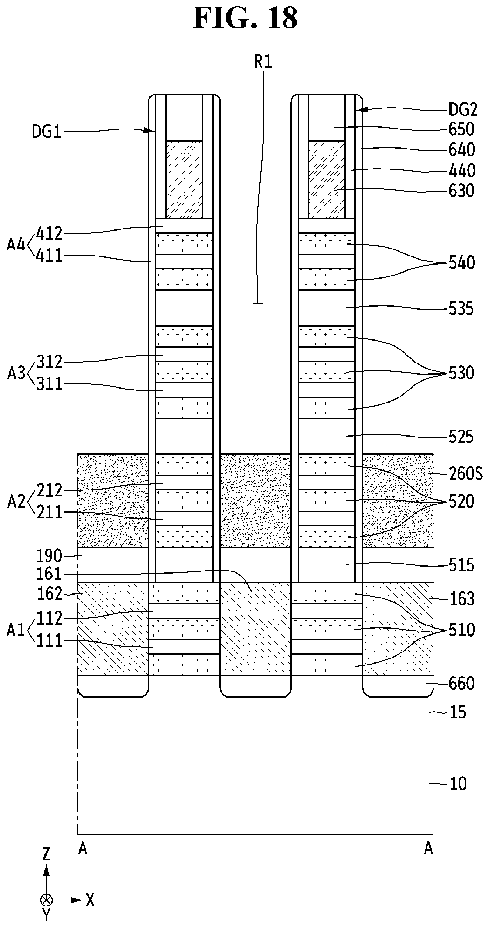

Referring to FIG. 18, a first sacrificial source/drain pattern 260S is formed on the first interlayer insulating film 190.

The first sacrificial source/drain pattern 260S may be formed within the first recesses R1. In one or more embodiments, the upper surface of the first sacrificial source/drain pattern 260S may be formed lower than the upper surface of the second gate separation pattern 525.

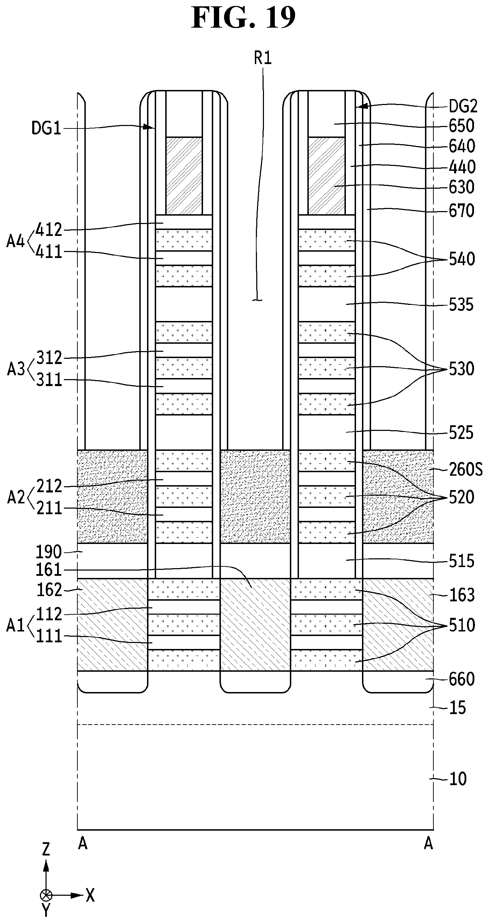

Referring to FIG. 19, a second liner film 670 is formed on the first liner film 640.

The second liner film 670 may expose the upper surface of the first sacrificial source/drain pattern 260S. For example, the second liner film 670 may conformally extend along the profile of the outer surface of the first liner film 640. The second liner film 670 may include an insulating material such as, for example, at least one from among silicon oxide, silicon nitride, silicon oxynitride, silicon oxycarbide, silicon boron nitride, silicon boron carbonitride, silicon oxycarbonitride, and a combination thereof, but embodiments of the disclosure are not limited thereto.

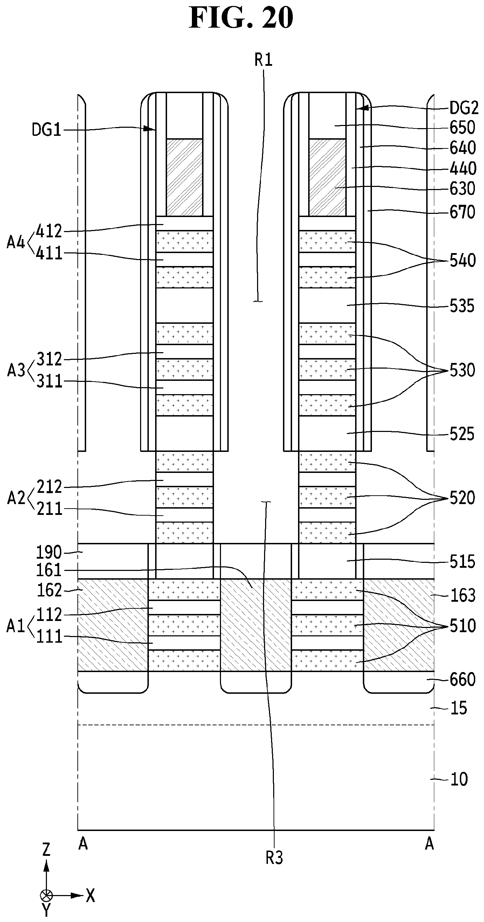

Referring to FIG. 20, the second liner film 670 is used to expose the second active pattern A2.

For example, an etching process may be performed on the first sacrificial source/drain pattern 260S using the second liner film 670. Thereafter, as the first sacrificial source/drain pattern 260S is removed, part of the first liner film 640 that is exposed may also be etched. Through this, third recesses R3 are formed, exposing the second active pattern A2 and the second sacrificial pattern 520 from the first liner film 640 and the second liner film 670.

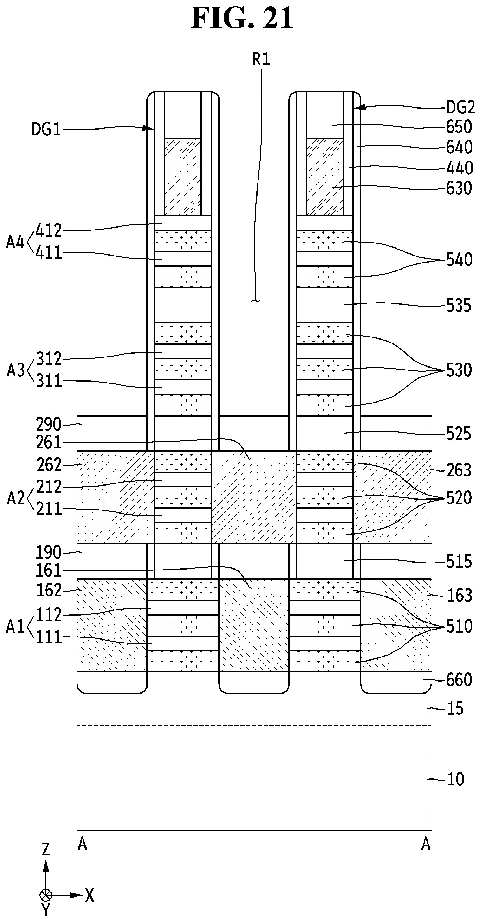

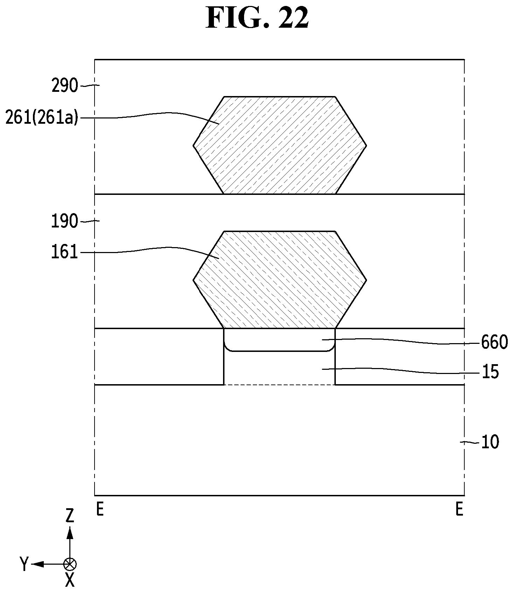

Referring to FIGS. 21 and 22, second-level source/drain patterns (e.g., the fourth through sixth source/drain patterns 261 through 263) and a second interlayer insulating film 290 are formed.

The formation of the second-level source/drain patterns (e.g., the fourth through sixth source/drain patterns 261 through 263) and the second interlayer insulating film 290 may be similar to the formation of the first-level source/drain patterns (e.g., the first through third source/drain patterns 161 through 163) and the first interlayer insulating film 190, and thus, a repeated explanation thereof may be omitted.

The fourth source/drain pattern 261 may include a first base portion 261a that overlaps with the first source/drain pattern 161 in a third direction Z.

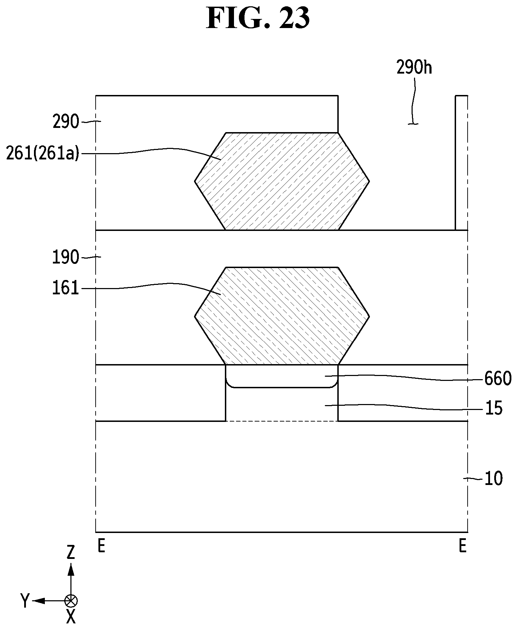

Referring to FIG. 23, part of the fourth source/drain pattern 261 is exposed.

For example, a source/drain hole 290h exposing part of the fourth source/drain pattern 261 may be formed within the second interlayer insulating film 290. In one or more embodiments, at least part of the source/drain hole 290h may not overlap with the first source/drain pattern 161 in the third direction Z. For example, at least part of the source/drain hole 290h may be arranged along the second direction Y with the first base portion 261a.

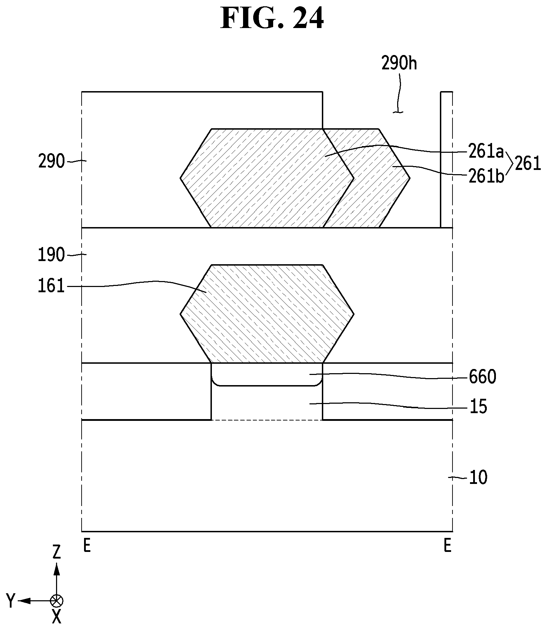

Referring to FIG. 24, an epitaxial growth process is performed using the first base portion 261a as a seed layer.

As the epitaxial growth process is performed, the first extension portion 261b may grow in the second direction Y from the first base portion 261a. Through this, the fourth source/drain pattern 261, including the first base portion 261a and the first extension portion 261b, may be formed.

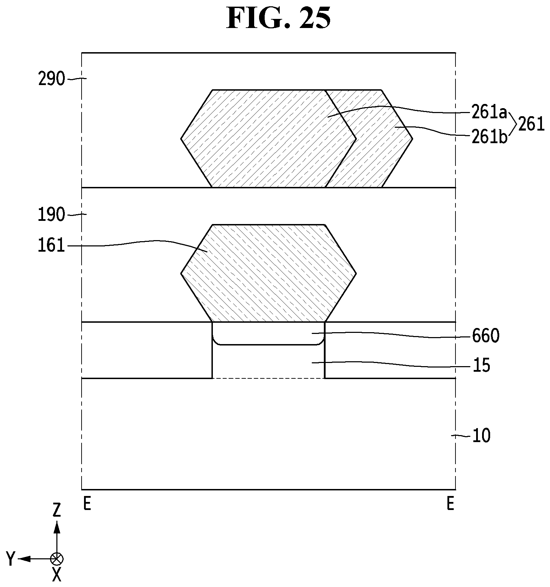

Referring to FIG. 25, the second interlayer insulating film 290 is formed.

For example, an insulating material filling the source/drain hole 290h may be formed. Through this, the second interlayer insulating film 290 covering the fourth source/drain pattern 261 may be formed.

Only the fourth source/drain pattern 261, including the first base portion 261a and the first extension portion 261b, has been described so far with reference to FIGS. 22 through 25, but those skilled in the art to which the disclosure pertains will understand that the sixth source/drain pattern 263, including the second base portion 263a and the second extension portion 263b, and the fifth source/drain pattern 262, including the fourth base portion 262a and the fourth extension portion 262b, can also be similarly formed.

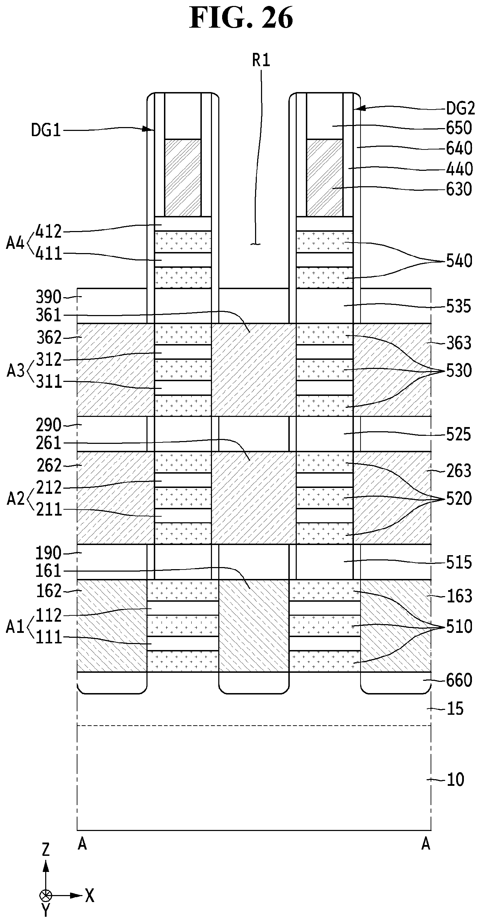

Referring to FIG. 26, third-level source/drain patterns (e.g., a seventh source/drain pattern 361, an eleventh source/drain pattern 362, and an eighth source/drain pattern 363) and a third interlayer insulating film 390 are formed.

The formation of the third-level source/drain patterns (e.g., the seventh source/drain pattern 361, the eleventh source/drain pattern 362, and the eighth source/drain pattern 363) and the third interlayer insulating film 390 may be similar to the formation of the second-level source/drain patterns (e.g., the fourth through sixth source/drain patterns 261 through 263) and the second interlayer insulating film 290, and thus, a repeated explanation thereof may be omitted.

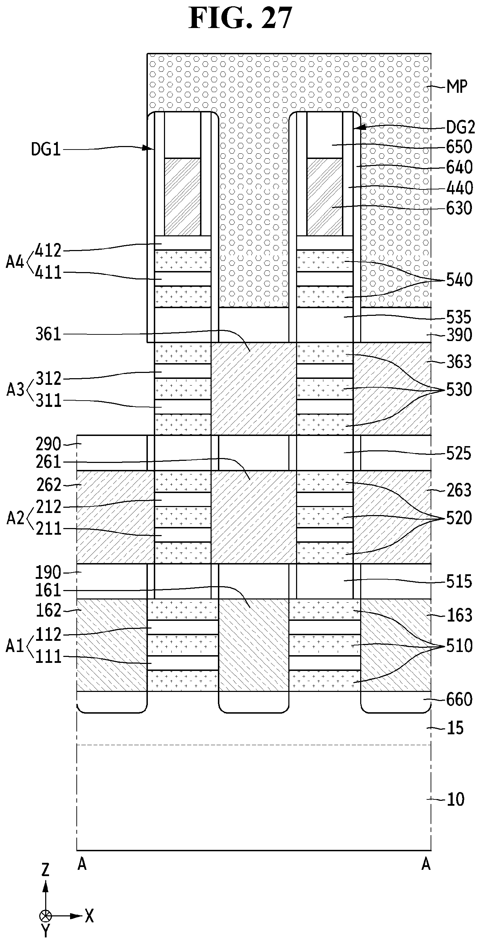

Referring to FIG. 27, parts of the third-level source/drain patterns (e.g., the seventh source/drain pattern 361, the eleventh source/drain pattern 362, and the eighth source/drain pattern 363) are removed.

For example, a second mask pattern MP that exposes the eleventh source/drain pattern 362 may be formed on the first dummy gate structure DG1, the second dummy gate structure DG2, and the third interlayer insulating film 390. Thereafter, an etching process may be performed on the eleventh source/drain pattern 362 using the second mask pattern MP. Through this, the third-level source/drain patterns, which include the seventh source/drain pattern 361 and the eighth source/drain pattern 363, may be formed.

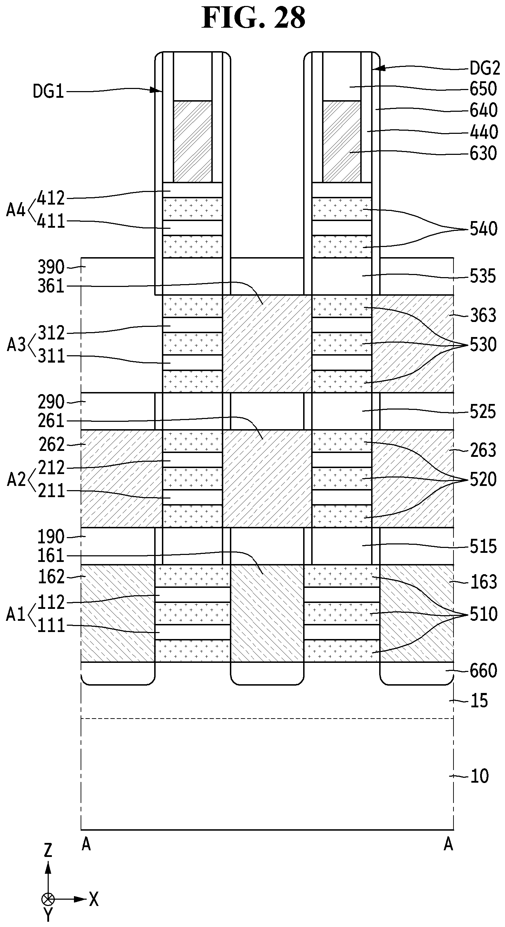

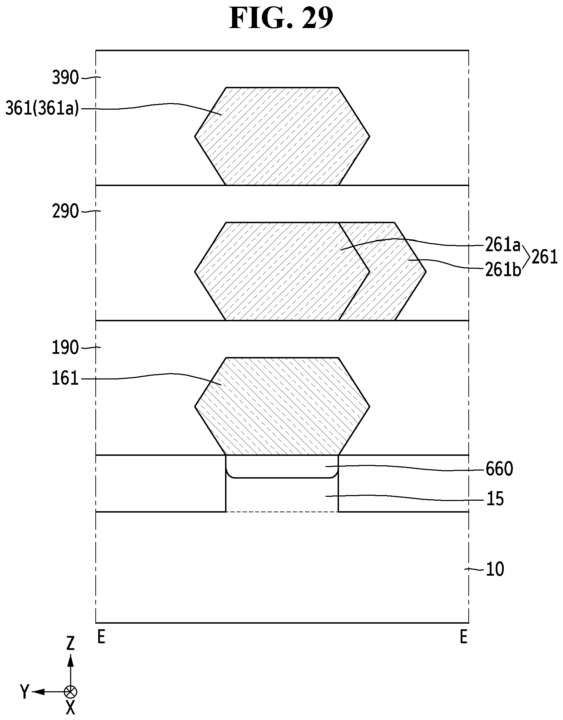

Referring to FIGS. 28 and 29, a third interlayer insulating film 390 is formed.

For example, an insulating material that fills the region where the eleventh source/drain pattern 362 has been removed may be formed. Through this, the third interlayer insulating film 390 that covers the third-level source/drain patterns (e.g., the seventh source/drain pattern 361 and the eighth source/drain pattern 363) may be formed.

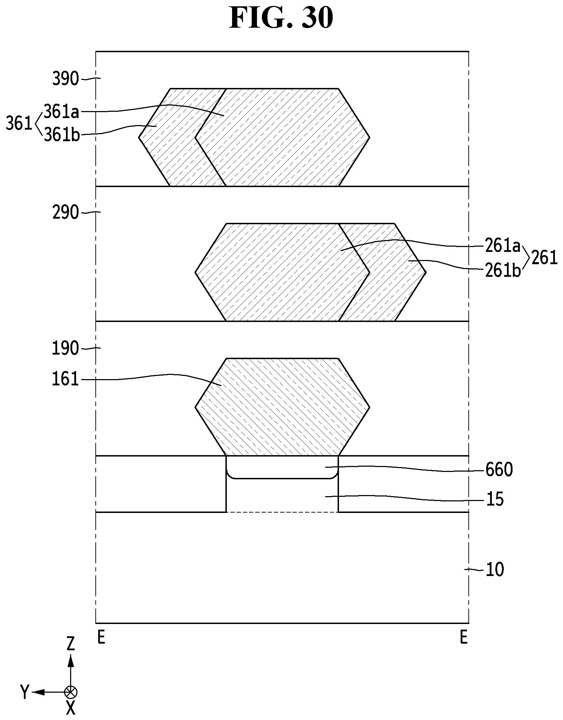

Referring to FIG. 30, the seventh source/drain pattern 361, including the third base portion 361a and the third extension portion 361b, is formed.

The formation of the seventh source/drain pattern 361, including the third base portion 361a and the third extension portion 361b, may be similar to the formation of the fourth source/drain pattern 261, including the first base portion 261a and the second extension portion 263b, and thus, a repeated explanation thereof may be omitted.

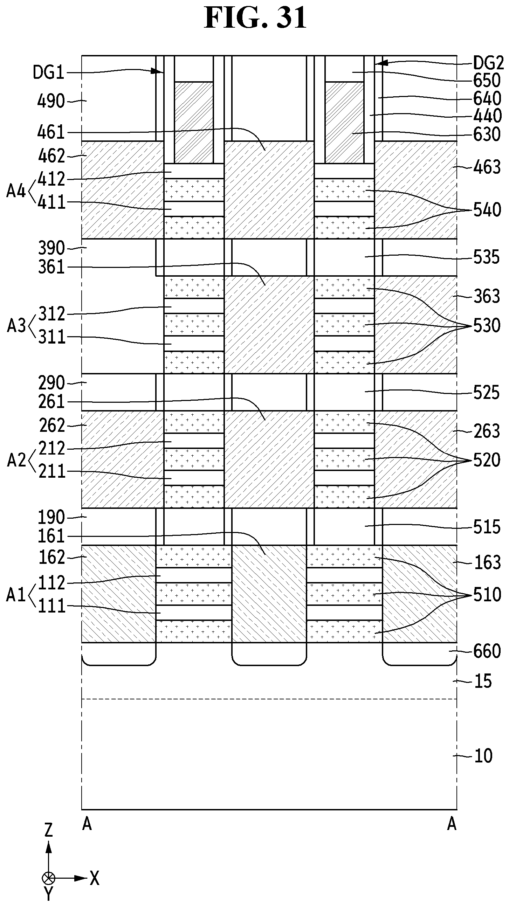

Referring to FIG. 31, fourth-level source/drain patterns (e.g., a ninth source/drain pattern 461, a tenth source/drain pattern 462, and an eleventh source/drain pattern 463) and a fourth interlayer insulating film 490 are formed.

The formation of the fourth-level source/drain patterns (e.g., the ninth source/drain pattern 461, the tenth source/drain pattern 462, and the eleventh source/drain pattern 463) and the fourth interlayer insulating film 490 may be similar to the formation of the third-level source/drain patterns (e.g., the seventh source/drain pattern 361, the eleventh source/drain pattern 362, and the eighth source/drain pattern 363) and the third interlayer insulating film 390, so a repeated explanation may be omitted here.

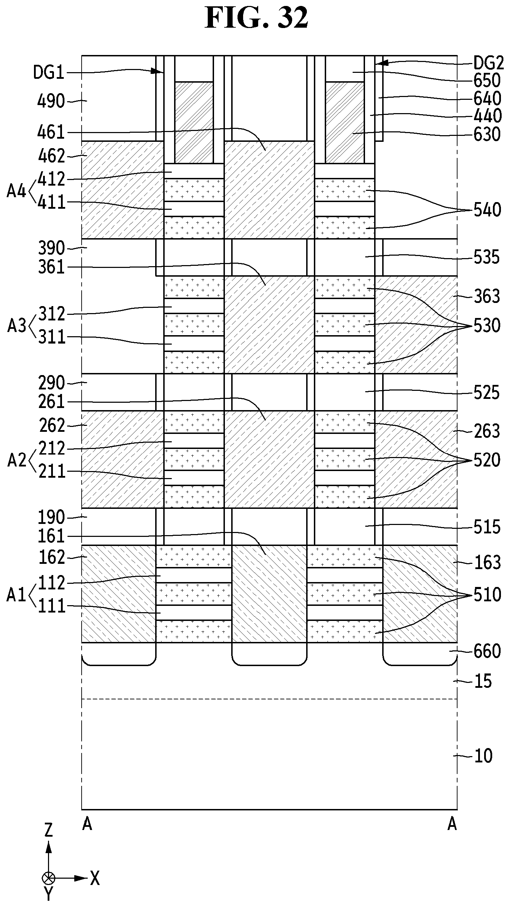

Referring to FIG. 32, parts of the fourth-level source/drain patterns (e.g., the ninth source/drain pattern 461, the tenth source/drain pattern 462, and the eleventh source/drain pattern 463) are removed.

The removal of parts of the fourth-level source/drain patterns (e.g., the ninth source/drain pattern 461, the tenth source/drain pattern 462, and the eleventh source/drain pattern 463) may be similar to the removal of parts of the third-level source/drain patterns (e.g., the seventh source/drain pattern 361, the eleventh source/drain pattern 362, and the eighth source/drain pattern 363), and thus, a repeated explanation thereof may be omitted. Through this, the fourth-level source/drain patterns (e.g., the ninth source/drain pattern 461 and the tenth source/drain pattern 462), including the ninth source/drain pattern 461 and the tenth source/drain pattern 462, may be formed.

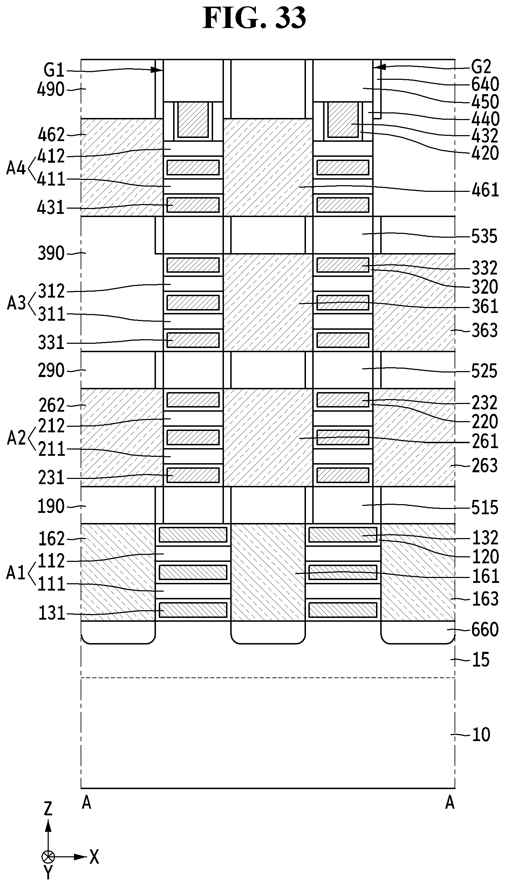

Referring to FIG. 33, the first gate structure G1 and the second gate structure G2 are formed.

For example, the first mask pattern 650 may be removed. Thereafter, the dummy gate electrode 630 and the first, second, third, and fourth sacrificial patterns 510, 520, 530, and 540 may be selectively removed. Thereafter, first, second, third, and fourth gate dielectric films 120, 220, 320, and 420 may be formed in the regions where the dummy gate electrode 630 and the first through fourth sacrificial patterns 510, 520, 530, and 540 have been removed. Thereafter, first, second, third, and fourth gate electrodes 131, 231, 331, and 431 and fifth, sixth, seventh, and eighth gate electrodes 132, 232, 332, and 432 may be formed on the first, second, third, and fourth gate dielectric films 120, 220, 320, and 420. Thereafter, a gate capping film 450 may be formed to cover the fourth and eighth gate electrodes 431 and 432.

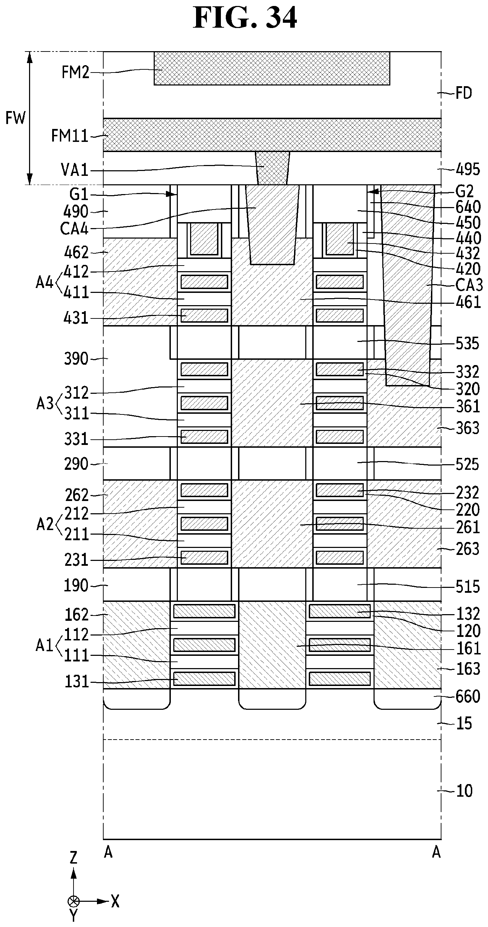

Referring to FIG. 34, frontside source/drain contacts (e.g., the first frontside source/drain contact CA4 and the second frontside source/drain contact CA3) and a frontside wiring structure FW are formed on the first gate structure G1, the second gate structure G2, and the fourth interlayer insulating film 490.

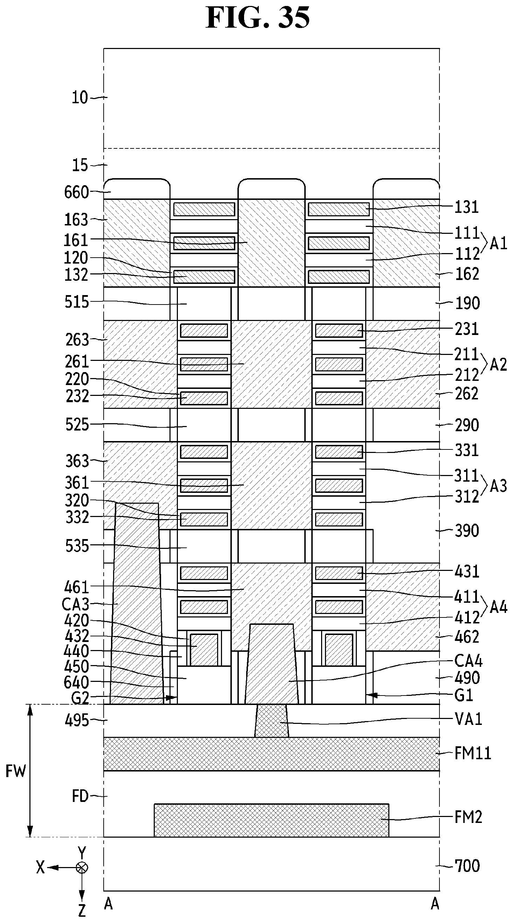

Referring to FIG. 35, the frontside wiring structure FW is attached to a carrier substrate 700.

For example, the carrier substrate 700 may be attached to the result from FIG. 34. After the carrier substrate 700 is attached, the result from FIG. 34 may be inverted.

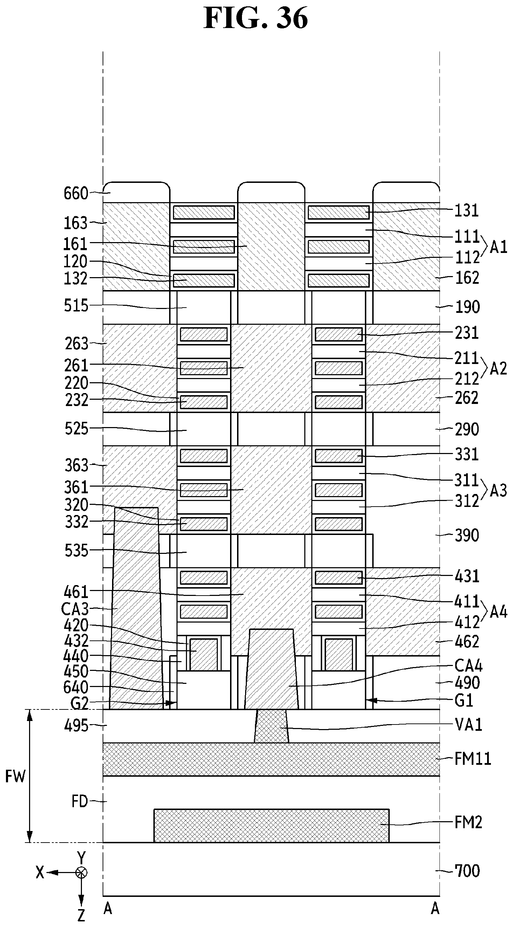

Referring to FIG. 36, the base substrate 10 and the fin pattern 15 are removed.

In one or more embodiments, the base substrate 10 and the fin pattern 15 may be selectively removed relative to the holder pattern 660.

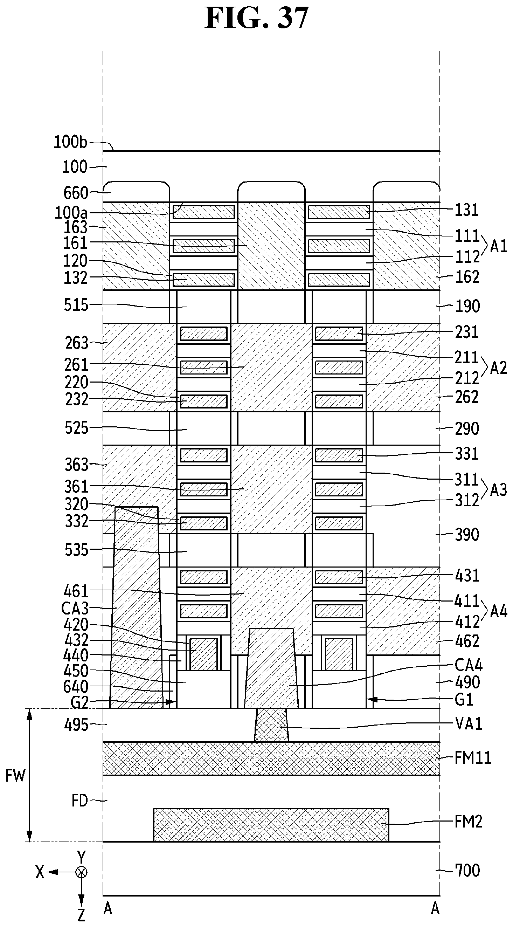

Referring to FIG. 37, a substrate 100 is formed.

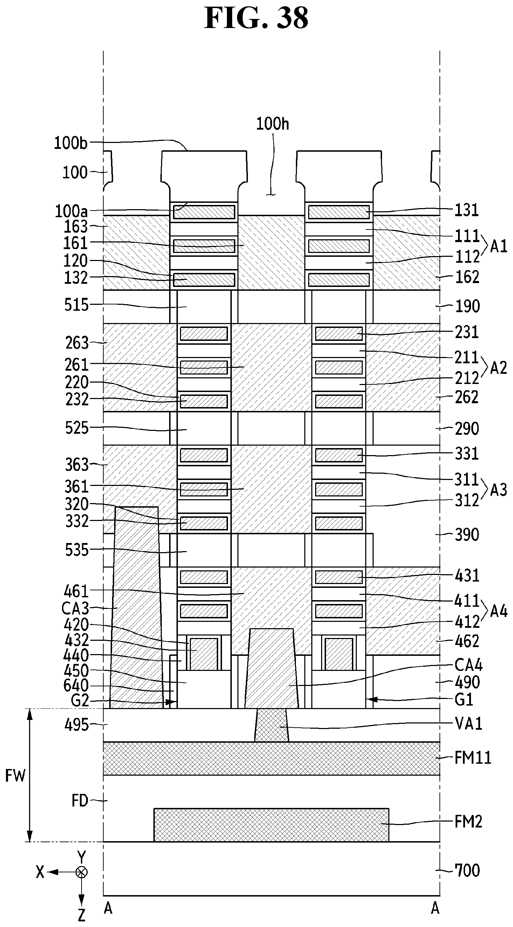

Referring to FIG. 38, contact holes 100h are formed in the substrate 100.

The contact holes 100h may expose the first-level source/drain patterns (e.g., the first through third source/drain patterns 161 through 163). For example, a preliminary contact hole exposing the holder pattern 660 may be formed. Thereafter, an etching process may be performed on the holder pattern 660 using the preliminary contact hole. Through this, the first-level source/drain patterns (e.g., the first through third source/drain patterns 161 through 163) may be exposed.

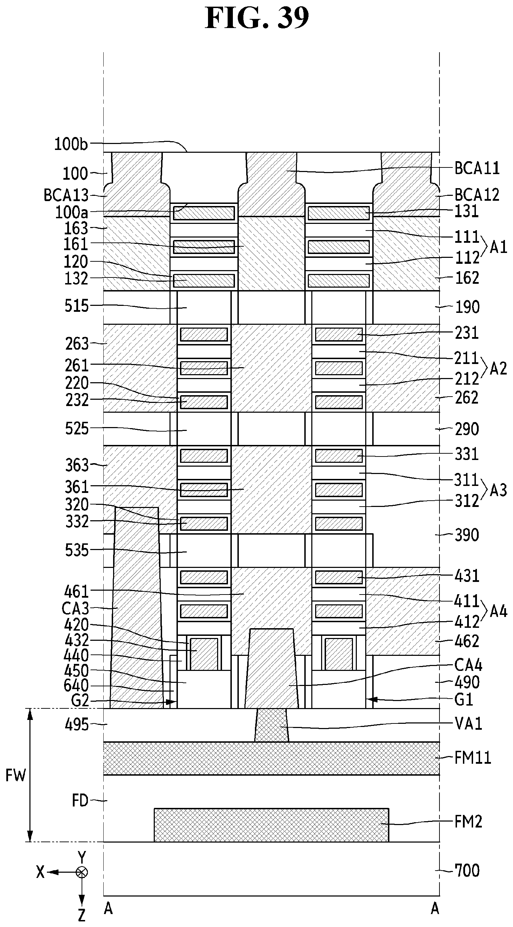

Referring to FIG. 39, backside source/drain contacts (e.g., the first through seventh backside source/drain contacts BCA11, BCA12, BCA13, BCA21, BCA22, BCA3, and BCA4) are formed.

For example, first, second, and third backside source/drain contacts BCA11, BCA12, and BCA13 filling the contact holes 100h may be formed. Through this, the backside source/drain contacts (e.g., the first through seventh backside source/drain contacts BCA11, BCA12, BCA13, BCA21, BCA22, BCA3, and BCA4), connected to the first through fourth active patterns A1 through A4, may be formed.

Thereafter, referring again to FIG. 3, a backside wiring structure BW may be formed on the substrate 100 and the backside source/drain contacts (e.g., the first through seventh backside source/drain contacts BCA11, BCA12, BCA13, BCA21, BCA22, BCA3, and BCA4). Through this, the semiconductor device described earlier using FIGS. 1 through 9 can be manufactured.

Embodiments are set out in the following clauses:
Clause 1. A semiconductor device comprising: a substrate comprising a first surface and a second surface opposite to the first surface; a first active pattern and a second active pattern sequentially stacked on the first surface, the first active pattern and the second active pattern extending in a first direction and being spaced apart from each other; a first gate electrode and a second gate electrode that extend in a second direction that intersects the first direction, the first gate electrode intersecting the first active pattern, and the second gate electrode intersecting the second active pattern; a first-level source/drain pattern on a sidewall of the first gate electrode and connected to the first active pattern; a second-level source/drain pattern on a sidewall of the second gate electrode and connected to the second active pattern; a first backside source/drain contact penetrating the substrate and connected to the first-level source/drain pattern; a second backside source/drain contact penetrating the substrate and connected to the second-level source/drain pattern; a connection wiring pattern on the second surface and connecting the first backside source/drain contact and the second backside source/drain contact; and a backside gate contact penetrating the substrate and connected to the first gate electrode and the second gate electrode, wherein the second-level source/drain pattern comprises: a first base portion overlapping the first-level source/drain pattern in a third direction that intersects the first direction and the second direction; and a first extension portion extending from the first base portion in the second direction and not overlapping the first-level source/drain pattern in the third direction, and wherein the second backside source/drain contact is connected to the first extension portion.
Clause 2. The semiconductor device of clause 1, wherein the first-level source/drain pattern comprises an impurity of a first conductivity type, and the second-level source/drain pattern comprises an impurity of a second conductivity type that is different from the first conductivity type.
Clause 3. The semiconductor device of clause 1 or 2, further comprising: a third backside source/drain contact penetrating the substrate and connected to the first-level source/drain pattern, wherein the first gate electrode and the second gate electrode are between the first backside source/drain contact and the third backside source/drain contact; and a fourth backside source/drain contact penetrating the substrate and connected to the second-level source/drain pattern, wherein the first gate electrode and the second gate electrode are between the second backside source/drain contact and the fourth backside source/drain contact, wherein the third backside source/drain contact is configured to receive a first power supply voltage, and wherein the fourth backside source/drain contact is configured to receive a second power supply voltage that is different from the first power supply voltage.
Clause 4. The semiconductor device of clause 3, wherein the first backside source/drain contact is between the third backside source/drain contact and the fourth backside source/drain contact in the second direction.
Clause 5. The semiconductor device of any preceding clause, further comprising: a third active pattern and a fourth active pattern sequentially stacked on the second active pattern, the third active pattern and the fourth active pattern extending in the first direction and being spaced apart from each other; a third gate electrode and a fourth gate electrode that extend in the second direction, the third gate electrode intersecting the third active pattern, and the fourth gate electrode intersecting the fourth active pattern; a third-level source/drain pattern on a sidewall of the third gate electrode and connected to the third active pattern; and a fourth-level source/drain pattern on a sidewall of the fourth gate electrode and connected to the fourth active pattern, wherein the fourth-level source/drain pattern comprises a second base portion overlapping the first base portion in the third direction, and a second extension portion extending from the second base portion in the second direction and overlapping the first extension portion in the third direction, and wherein the second backside source/drain contact is connected to the first extension portion and the second extension portion.
Clause 6. The semiconductor device of clause 5, further comprising: a frontside source/drain contact on the first surface and connected to the fourth-level source/drain pattern, wherein the fourth gate electrode is between the frontside source/drain contact and the second backside source/drain contact.
Clause 7. The semiconductor device of any preceding clause, further comprising: a third active pattern and a fourth active pattern sequentially stacked on the second active pattern, the third active pattern and the fourth active pattern extending in the first direction and spaced apart from each other; a third gate electrode and a fourth gate electrode that extend in the second direction, the third gate electrode intersecting the third active pattern, and the fourth gate electrode intersecting the fourth active pattern; a third-level source/drain pattern on a sidewall of the third gate electrode and connected to the third active pattern; a fourth-level source/drain pattern on a sidewall of the fourth gate electrode and connected to the fourth active pattern; a first frontside source/drain contact on the first surface and connected to the third-level source/drain pattern; and a second frontside source/drain contact on the first surface and connected to the fourth-level source/drain pattern.
Clause 8. The semiconductor device of clause 7, wherein the fourth gate electrode is between the first frontside source/drain contact and the second frontside source/drain contact, and the first frontside source/drain contact is spaced apart from the fourth-level source/drain pattern.
Clause 9. The semiconductor device of any preceding clause, further comprising: a gate separation pattern between the first gate electrode and the second gate electrode, the gate separation pattern extending in the second direction, wherein the backside gate contact penetrates the gate separation pattern.
Clause 10. The semiconductor device of any preceding clause, wherein each of the first active pattern and the second active pattern comprises a plurality of bridge patterns that are stacked and spaced apart from each other.
Clause 11. A semiconductor device comprising: a substrate; a first active pattern, a second active pattern, a third active pattern, and a fourth active pattern sequentially stacked and spaced apart from one another, on the substrate; a first gate electrode, a second gate electrode, a third gate electrode, and a fourth gate electrode sequentially stacked on the substrate and intersecting the first active pattern, the second active pattern, the third active pattern, and the fourth active pattern, respectively; a fifth gate electrode, a sixth gate electrode, a seventh gate electrode, and an eighth gate electrode sequentially stacked on the substrate and intersecting the first active pattern, the second active pattern, the third active pattern, and the fourth active pattern, respectively, wherein the fifth gate electrode, the sixth gate electrode, the seventh gate electrode, and the eighth gate electrode are spaced apart from the first gate electrode, the second gate electrode, the third gate electrode, and the fourth gate electrode; a first source/drain pattern between the first gate electrode and the fifth gate electrode and connected to the first active pattern; a second source/drain pattern connected to the first active pattern, the first gate electrode being between the first source/drain pattern and the second source/drain pattern; a third source/drain pattern connected to the first active pattern, the second gate electrode being between the first source/drain pattern and the third source/drain pattern; a fourth source/drain pattern between the second gate electrode and the sixth gate electrode and connected to the second active pattern; a fifth source/drain pattern connected to the second active pattern, the second gate electrode being between the fourth source/drain pattern and the fifth source/drain pattern; a sixth source/drain pattern connected to the second active pattern, the sixth gate electrode being between the fourth source/drain pattern and the sixth source/drain pattern; a seventh source/drain pattern between the third gate electrode and the seventh gate electrode and connected to the third active pattern; an eighth source/drain pattern connected to the third active pattern, the seventh gate electrode being between the seventh source/drain pattern and the eighth source/drain pattern; a ninth source/drain pattern between the fourth gate electrode and the eighth gate electrode and connected to the fourth active pattern; and a tenth source/drain pattern connected to the fourth active pattern, the fourth gate electrode being between the ninth source/drain pattern and the tenth source/drain pattern, wherein the second source/drain pattern, the fifth source/drain pattern, the tenth source/drain pattern, the fifth gate electrode, and the sixth gate electrode are electrically connected to each other, and wherein the third source/drain pattern, the sixth source/drain pattern, the seventh source/drain pattern, the first gate electrode, and the second gate electrode are electrically connected to each other.
Clause 12. The semiconductor device of clause 11, further comprising: a first backside source/drain contact penetrating the substrate and connected to the first source/drain pattern; and a second backside source/drain contact penetrating the substrate and connected to the fourth source/drain pattern, wherein the first backside source/drain contact is configured to receive a first power supply voltage, and wherein the second backside source/drain contact is configured to receive a second power supply voltage that is different from the first power supply voltage.
Clause 13. The semiconductor device of clause 12, wherein the fourth source/drain pattern comprises a base portion overlapping the first source/drain pattern, and an extension portion extending from the base portion and not overlapping the first source/drain pattern, and wherein the second backside source/drain contact contacts the extension portion.
Clause 14. The semiconductor device of clause 11, 12 or 13, further comprising: a first backside source/drain contact penetrating the substrate and connected to the second source/drain pattern; a second backside source/drain contact penetrating the substrate and connected to the fifth source/drain pattern and the tenth source/drain pattern; a backside gate contact penetrating the substrate and connected to the fifth gate electrode and the sixth gate electrode; and a connection wiring pattern on the substrate and connecting the first backside source/drain contact, the second backside source/drain contact, and the backside gate contact.
Clause 15. The semiconductor device of clause 14, wherein each of the fifth source/drain pattern and the tenth source/drain pattern comprises: a base portion overlapping the second source/drain pattern; and an extension portion extending from the base portion and not overlapping the second source/drain pattern, and wherein the second backside source/drain contact contacts the extension portion.
Clause 16. The semiconductor device of any of clauses 11 to 15, further comprising: a first backside source/drain contact penetrating the substrate and connected to the third source/drain pattern; a second backside source/drain contact penetrating the substrate and connected to the sixth source/drain pattern; a third backside source/drain contact penetrating the substrate and connected to the seventh source/drain pattern; a backside gate contact penetrating the substrate and connected to the first gate electrode and the second gate electrode; and a connection wiring pattern on the substrate and connecting the first backside source/drain contact, the second backside source/drain contact, the third backside source/drain contact, and the backside gate contact, on the substrate.
Clause 17. The semiconductor device of clause 16, wherein the sixth source/drain pattern comprises: a first base portion overlapping with the third source/drain pattern, and a first extension portion extending from the first base portion and not overlapping with the third source/drain pattern, the seventh source/drain pattern comprises: a second base portion overlapping with the first base portion, and a second extension portion extending from the second base portion and not overlapping with the first base portion and the first extension portion, wherein the second backside source/drain contact is in contact with the first extension portion, and wherein the third backside source/drain contact is in contact with the second extension portion.
Clause 18. The semiconductor device of any one of clauses 11 to 17, further comprising: a first frontside source/drain contact connected to an upper surface of the ninth source/drain pattern; a second frontside source/drain contact connected to an upper surface of the eighth source/drain pattern; a bitline connected to the first frontside source/drain contact; and a complementary bitline connected to the second frontside source/drain contact.
Clause 19. The semiconductor device of any one of clauses 11 to 18, further comprising: a first frontside gate contact connected to an upper surface of the fourth gate electrode; a second frontside gate contact connected to an upper surface of the seventh gate electrode; and a wordline connected to the frontside gate contact and the second frontside gate contact.
Clause 20. A semiconductor device comprising: a substrate comprising a first surface and a second surface that are opposite to each other; a first power supply line applied on the second surface and configured to receive a first power supply voltage, on the second surface; a second power supply line applied on the second surface and configured to receive a second power supply voltage, which is different from the first power supply voltage, on the second surface; a latch circuit comprising a first inverter and a second inverter arranged in parallel on the first surface, the first inverter and the second inverter being between the first power supply line and the second power supply line, on the first surface; a bitline on the first surface; and a complementary bitline extending side by side, on the first surface; a first pass transistor connecting the bitline and an output node of the first inverter; a second pass transistor connecting the complementary bitline and an output node of the second inverter; and a wordline on the first surface and connected to a gate of the first pass transistor and a gate of the second pass transistor, on the first surface, wherein the first inverter comprises a first pull-up transistor and a first pull-down transistor connected in series between the first power supply line and the second power supply line, wherein the second inverter comprises a second pull-up transistor and a second pull-down transistor connected in series between the first power supply line and the second power supply line, wherein the first pull-up transistor and the second pull-up transistor are disposed at a first level on the first surface, wherein the first pull-down transistor and the second pull-down transistor are disposed at a second level, that is higher than the first level, on the first surface, wherein the second pass transistor is disposed at a third level, that is higher than the second level, on the first surface, and wherein the first pass transistor is disposed at a fourth level, that is higher than the third level, on the first surface.

While non-limiting example embodiments of the disclosure have been described with reference to the accompanying drawings, it will be understood by those of ordinary skill in the art that various changes in form and details may be made therein without departing from the scope of the disclosure. Therefore the example embodiments should be considered in all respects as illustrative and not restrictive.

## Claims

1. A semiconductor device comprising:
a substrate comprising a first surface and a second surface opposite to the first surface;
a first active pattern and a second active pattern sequentially stacked on the first surface, the first active pattern and the second active pattern extending in a first direction and being spaced apart from each other;
a first gate electrode and a second gate electrode that extend in a second direction that intersects the first direction, the first gate electrode intersecting the first active pattern, and the second gate electrode intersecting the second active pattern;
a first-level source/drain pattern on a sidewall of the first gate electrode and connected to the first active pattern;
a second-level source/drain pattern on a sidewall of the second gate electrode and connected to the second active pattern;
a first backside source/drain contact penetrating the substrate and connected to the first-level source/drain pattern;
a second backside source/drain contact penetrating the substrate and connected to the second-level source/drain pattern;
a connection wiring pattern on the second surface and connecting the first backside source/drain contact and the second backside source/drain contact; and
a backside gate contact penetrating the substrate and connected to the first gate electrode and the second gate electrode,
wherein the second-level source/drain pattern comprises:
a first base portion overlapping the first-level source/drain pattern in a third direction that intersects the first direction and the second direction; and
a first extension portion extending from the first base portion in the second direction and not overlapping the first-level source/drain pattern in the third direction, and
wherein the second backside source/drain contact is connected to the first extension portion.

2. The semiconductor device of claim 1, wherein the first-level source/drain pattern comprises an impurity of a first conductivity type, and the second-level source/drain pattern comprises an impurity of a second conductivity type that is different from the first conductivity type.

3. The semiconductor device of claim 1 or 2, further comprising:
a third backside source/drain contact penetrating the substrate and connected to the first-level source/drain pattern, wherein the first gate electrode and the second gate electrode are between the first backside source/drain contact and the third backside source/drain contact; and
a fourth backside source/drain contact penetrating the substrate and connected to the second-level source/drain pattern, wherein the first gate electrode and the second gate electrode are between the second backside source/drain contact and the fourth backside source/drain contact,
wherein the third backside source/drain contact is configured to receive a first power supply voltage, and
wherein the fourth backside source/drain contact is configured to receive a second power supply voltage that is different from the first power supply voltage.

4. The semiconductor device of claim 3, wherein the first backside source/drain contact is between the third backside source/drain contact and the fourth backside source/drain contact in the second direction.

5. The semiconductor device of any preceding claim, further comprising:
a third active pattern and a fourth active pattern sequentially stacked on the second active pattern, the third active pattern and the fourth active pattern extending in the first direction and being spaced apart from each other;
a third gate electrode and a fourth gate electrode that extend in the second direction, the third gate electrode intersecting the third active pattern, and the fourth gate electrode intersecting the fourth active pattern;
a third-level source/drain pattern on a sidewall of the third gate electrode and connected to the third active pattern; and
a fourth-level source/drain pattern on a sidewall of the fourth gate electrode and connected to the fourth active pattern,
wherein the fourth-level source/drain pattern comprises a second base portion overlapping the first base portion in the third direction, and a second extension portion extending from the second base portion in the second direction and overlapping the first extension portion in the third direction, and
wherein the second backside source/drain contact is connected to the first extension portion and the second extension portion.

6. The semiconductor device of claim 5, further comprising:
a frontside source/drain contact on the first surface and connected to the fourth-level source/drain pattern,
wherein the fourth gate electrode is between the frontside source/drain contact and the second backside source/drain contact.

7. The semiconductor device of any preceding claim, further comprising:
a third active pattern and a fourth active pattern sequentially stacked on the second active pattern, the third active pattern and the fourth active pattern extending in the first direction and spaced apart from each other;
a third gate electrode and a fourth gate electrode that extend in the second direction, the third gate electrode intersecting the third active pattern, and the fourth gate electrode intersecting the fourth active pattern;
a third-level source/drain pattern on a sidewall of the third gate electrode and connected to the third active pattern;
a fourth-level source/drain pattern on a sidewall of the fourth gate electrode and connected to the fourth active pattern;
a first frontside source/drain contact on the first surface and connected to the third-level source/drain pattern; and
a second frontside source/drain contact on the first surface and connected to the fourth-level source/drain pattern.

8. The semiconductor device of claim 7, wherein
the fourth gate electrode is between the first frontside source/drain contact and the second frontside source/drain contact, and
the first frontside source/drain contact is spaced apart from the fourth-level source/drain pattern.

9. The semiconductor device of any preceding claim, further comprising:
a gate separation pattern between the first gate electrode and the second gate electrode, the gate separation pattern extending in the second direction,
wherein the backside gate contact penetrates the gate separation pattern.

10. The semiconductor device of any preceding claim, wherein each of the first active pattern and the second active pattern comprises a plurality of bridge patterns that are stacked and spaced apart from each other.

11. The semiconductor device of claim 1, further comprising:
a third active pattern, and a fourth active pattern sequentially stacked and spaced apart from one another, on the substrate;
a third gate electrode, and a fourth gate electrode sequentially stacked on the substrate and intersecting the third active pattern, and the fourth active pattern, respectively;
a fifth gate electrode, a sixth gate electrode, a seventh gate electrode, and an eighth gate electrode sequentially stacked on the substrate and intersecting the first active pattern, the second active pattern, the third active pattern, and the fourth active pattern, respectively, wherein the fifth gate electrode, the sixth gate electrode, the seventh gate electrode, and the eighth gate electrode are spaced apart from the first gate electrode, the second gate electrode, the third gate electrode, and the fourth gate electrode;
a first source/drain pattern between the first gate electrode and the fifth gate electrode and connected to the first active pattern;
a second source/drain pattern connected to the first active pattern, the first gate electrode being between the first source/drain pattern and the second source/drain pattern;
a third source/drain pattern connected to the first active pattern, the second gate electrode being between the first source/drain pattern and the third source/drain pattern;
a fourth source/drain pattern between the second gate electrode and the sixth gate electrode and connected to the second active pattern;
a fifth source/drain pattern connected to the second active pattern, the second gate electrode being between the fourth source/drain pattern and the fifth source/drain pattern;
a sixth source/drain pattern connected to the second active pattern, the sixth gate electrode being between the fourth source/drain pattern and the sixth source/drain pattern;
a seventh source/drain pattern between the third gate electrode and the seventh gate electrode and connected to the third active pattern;
an eighth source/drain pattern connected to the third active pattern, the seventh gate electrode being between the seventh source/drain pattern and the eighth source/drain pattern;
a ninth source/drain pattern between the fourth gate electrode and the eighth gate electrode and connected to the fourth active pattern; and
a tenth source/drain pattern connected to the fourth active pattern, the fourth gate electrode being between the ninth source/drain pattern and the tenth source/drain pattern,
wherein the second source/drain pattern, the fifth source/drain pattern, the tenth source/drain pattern, the fifth gate electrode, and the sixth gate electrode are electrically connected to each other, and
wherein the third source/drain pattern, the sixth source/drain pattern, the seventh source/drain pattern, the first gate electrode, and the second gate electrode are electrically connected to each other.

12. The semiconductor device of claim 11, further comprising:
the first backside source/drain contact penetrating the substrate and connected to the first source/drain pattern; and
the second backside source/drain contact penetrating the substrate and connected to the fourth source/drain pattern,
wherein the first backside source/drain contact is configured to receive a first power supply voltage, and
wherein the second backside source/drain contact is configured to receive a second power supply voltage that is different from the first power supply voltage.

13. The semiconductor device of claim 12, wherein
the fourth source/drain pattern comprises a base portion overlapping the first source/drain pattern, and an extension portion extending from the base portion and not overlapping the first source/drain pattern, and
wherein the second backside source/drain contact contacts the extension portion.

14. The semiconductor device of claim 11, 12 or 13, further comprising:
the first backside source/drain contact penetrating the substrate and connected to the second source/drain pattern;
the second backside source/drain contact penetrating the substrate and connected to the fifth source/drain pattern and the tenth source/drain pattern;
the backside gate contact penetrating the substrate and connected to the fifth gate electrode and the sixth gate electrode; and
the connection wiring pattern connecting the first backside source/drain contact, the second backside source/drain contact, and the backside gate contact.

15. The semiconductor device of claim 14, wherein
each of the fifth source/drain pattern and the tenth source/drain pattern comprises:
a base portion overlapping the second source/drain pattern; and
an extension portion extending from the base portion and not overlapping the second source/drain pattern, and
wherein the second backside source/drain contact contacts the extension portion.
